# EUROPEAN PATENT APPLICATION

(11) **EP 4 783 612 A1**
(43) Date of publication of application: **29.07.2026**
(21) Application number: 24868409.4
(22) Date of filing: 30.04.2024
(51) Int. Cl.: H04R 19/04, H04R 19/00, H04R 31/00

(54) **MEMS MICROPHONE**

(30) Priority: 22.09.2023 KR 20230127526
(71) Applicant: LG Innotek Co., Ltd., Seoul 07796 (KR)
(72) Inventor: KIM, Young Kweon, Seoul 07796 (KR); KANG, Byeong Kil, Seoul 07796 (KR); KIM, Hak Hae, Seoul 07796 (KR)
(74) Representative: DREISS Patentanwälte PartG mbB
(86) International application number: PCT/KR2024/005899
(87) International publication number: WO 2025/063422

(57) **Abstract**

A MEMS microphone according to one embodiment of the present invention comprises: a first substrate; a second substrate stacked on the first substrate; a MEMS structure disposed on the second substrate, and a capacitor spaced apart from the MEMS structure and disposed on the second substrate, wherein the second substrate includes at least one hole, and the capacitor is electrically connected to the first substrate through a wire passing through the hole of the second substrate.

## Description

### [Technical Field]

The present invention relates to a MEMS microphone, and more specifically, to a MEMS microphone using COF.

### [Background Art]

In general, audio devices generate sound by vibrating a diaphragm using electrodes, and with recent technological developments, great progress is being made in the field of audio devices. The field, in which these audio devices are used, such as portable terminals and hearing aids, are becoming more diverse, and as devices to which the audio devices are applied are becoming slimmer, the size of the audio devices themselves is also being miniaturized.

In addition, recently, a micro phone using micro electro mechanical systems (MEMS), a semiconductor technology, has been developed and used. MEMS is a technology that enables the fabrication of small mechanical components on a surface of a silicon wafer. These MEMS microphones can be divided into electrostatic and piezoelectric types, and include common condenser types.

Recently, mobile communication terminals such as mobile phones and smartphones, and electronic devices such as tablet PCs and MP3 players are becoming more miniaturized. Accordingly, components of electronic devices are also becoming miniaturized. Accordingly, micro electro mechanical system (MEMS) technology that can solve the physical limitations of components is needed.

### [Detailed Description of the Invention]

### [Technical Subject]

The technical problem to be solved by the present invention is to provide a MEMS microphone using COF.

### [Means for Solving the Problem]

In order to solve the above technical problem, a MEMS microphone according to an embodiment of the present invention comprises: a first substrate; a second substrate being stacked on the first substrate; a MEMS structure being disposed on the second substrate; and a capacitor being spaced apart from the MEMS structure and disposed on the second substrate and, wherein the second substrate includes one or more holes, and wherein the capacitor is electrically connected to the first substrate through a wire passing through a hole of the second substrate.

In addition, the hole of the second substrate may include: a first hole through which a wire connecting the capacitor and the first substrate penetrates; and a second hole corresponding to a lower portion of the MEMS structure.

In addition, the hole of the second substrate may include: a first hole through which a wire connecting the capacitor and the first substrate penetrates; and a second hole corresponding to the lower portion of the MEMS structure. In addition, the hole of the second substrate may include: a first hole through which a wire connecting the capacitor and the first substrate penetrates; and a second hole corresponding to the lower portion of the MEMS structure.

In addition, the hole of the second substrate may be formed by being spaced apart at a predetermined distance or more from the outer perimeter of the second substrate.

In addition, a conductive adhesive layer may be included between the first substrate and the second substrate, and the conductive adhesive layer may include a hole being overlapped with the hole of the second substrate.

In addition, the area of the hole in the conductive adhesive layer may be larger than the area of the hole in the second substrate.

In addition, the first substrate may include a connection pad being disposed at a position corresponding to a lower portion of the hole of the second substrate.

In addition, it includes an ASIC module being disposed on the second substrate and spaced apart from the MEMS structure, and the ASIC module may be electrically connected to the first substrate through a wire passing through the hole of the second substrate.

In addition, the ASIC module may be electrically connected to the MEMS structure and the capacitor through wires, respectively.

In addition, the first substrate may be a flexible substrate, and the second substrate may be a rigid substrate.

In addition, the first substrate and the second substrate can be bonded by thermal compression.

In order to solve the above technical problem, a MEMS microphone according to a second embodiment of the present invention comprises: a first substrate; a second substrate being stacked on at least one region of the first substrate; a MEMS structure and a signal processing element being disposed on the second substrate; a first capacitor being stacked on the first substrate on which the second substrate is not stacked; and a second capacitor being stacked on a lower portion of the signal processing element.

In addition, the first electrode of the second capacitor is electrically connected to the first substrate, and the second electrode of the second capacitor may be electrically connected to the second substrate.

In addition, the first electrode of the second capacitor may be disposed at a lower portion of the second capacitor and bonded to the first substrate by soldering.

In addition, on an upper portion of the second capacitor, it may include: a conductive adhesive layer electrically connecting the second capacitor and the second substrate; and a non-conductive adhesive layer being stacked between the conductive adhesive layer and the signal processing element.

In addition, the second substrate may include an etching region in the region where the second capacitor is disposed.

In addition, the signal processing element may be connected to the MEMS structure and the first substrate with a wire, respectively.

In order to solve the above technical problem, a MEMS microphone according to another embodiment of a second embodiment of the present invention comprises: a first substrate; a second substrate being stacked on at least one region of the first substrate; a housing covering the second substrate; a MEMS structure being disposed on the second substrate; a first capacitor being spaced apart from the MEMS structure and disposed on the second substrate; and a second capacitor being stacked on a lower portion of the first capacitor.

In addition, the first electrode of the first capacitor is located on the second capacitor, and the second electrode of the first capacitor may be located on the second substrate.

In addition, the first electrode of the second capacitor is electrically connected to the first electrode of the first capacitor, and the second electrode of the second capacitor may be electrically connected to the first substrate.

In addition, the second substrate may include an etching region in the region where the second capacitor is disposed.

In addition, it includes a metal portion being stacked on a lower portion of the first capacitor, wherein the first electrode of the first capacitor is located on the second capacitor, and wherein the second electrode of the first capacitor may be located on the metal portion.

In addition, the first electrode of the first capacitor may be connected to the first substrate with a wire.

In addition, the second substrate includes a half-etched region where the metal portion and the second capacitor are disposed, wherein the thickness of the half-etched region may be thinner than the thickness of other regions.

In addition, it includes a third capacitor being stacked on a lower portion of the first capacitor, wherein the first electrode of the first capacitor is located on the second capacitor, and wherein the second electrode of the first capacitor may be located on the third capacitor.

In addition, the second electrode of the first capacitor may be electrically connected to the first electrode of the third capacitor.

In addition, the first electrode of the first capacitor may be connected to the first substrate with a wire.

In addition, the second substrate includes a half-etched region where the second capacitor and the third capacitor are disposed, and the thickness of the half-etched region may be thinner than the thickness of other regions.

In order to solve the above technical problem, the MEMS microphone according to yet another embodiment of a second embodiment of the present invention comprises: a first substrate; a second substrate being stacked on at least one region of the first substrate; a housing covering the second substrate; a MEMS structure being disposed on the second substrate; a first capacitor being disposed on the first substrate on which the second substrate is not stacked; a second capacitor being stacked on a lower portion of the first electrode of the first capacitor; and a fourth capacitor being stacked on a lower portion of the second electrode of the first capacitor.

In addition, the first electrode of the second capacitor is electrically connected to the first electrode of the first capacitor; the second electrode of the second capacitor is electrically connected to the first substrate; the first electrode of the fourth capacitor is electrically connected to the first substrate; and the second electrode of the fourth capacitor may be electrically connected to the second electrode of the first capacitor.

In addition, the first electrode of the first capacitor may be connected to the first substrate with a wire.

In order to solve the above technical problem, the MEMS microphone according to the third embodiment of the present invention comprises: a first substrate; a second substrate being stacked on at least one region of the first substrate; a MEMS structure and a signal processing element being disposed on the second substrate; and a capacitor element being stacked on the first substrate on which the second substrate is not stacked, wherein the capacitor element includes a capacitor and an interposer being stacked on a lower portion of the capacitor.

In addition, the interposer includes an FR4 printed circuit substrate, wherein the capacitor may be surface mounted on the printed circuit substrate.

In addition, the interposer includes a metal plate, wherein the capacitor may be mounted on the metal plate.

In addition, the metal plate includes a first metal plate and a second metal plate, wherein the first metal plate and the second metal plate may form a bridge structure respectively bonded to both electrodes of the capacitor.

In addition, the interposer may include any one among an FR4 printed circuit substrate, a metal plate, a lead frame, a ceramic printed circuit substrate, and a metal printed circuit substrate.

In addition, the capacitor element may be soldered onto the first substrate.

In addition, the capacitor element is disposed to be spaced apart from the signal processing element, but may be electrically connected to the signal processing element.

In addition, the signal processing element may include an ASIC module.

In addition, the first substrate may be a flexible substrate, and the second substrate may be a rigid substrate.

In addition, the first substrate and the second substrate can be bonded by thermal compression.

In order to solve the above technical problem, a MEMS microphone according to a fourth embodiment of the present invention comprises: a first substrate; a second substrate being stacked on at least one region of the first substrate; a conductive adhesive layer being stacked between the first substrate and the second substrate; an upper adhesive layer being stacked on the second substrate; and a MEMS structure and a signal processing element being disposed on the upper adhesive layer, wherein the MEMS structure is directly bonded to the upper adhesive layer, and wherein the upper adhesive layer includes a coverlay or a photo solder resist.

In order to solve the above technical problem, a MEMS microphone according to another embodiment of a fourth embodiment of the present invention comprises: a first substrate; a first photo solder resist layer being stacked on at least one region of the first substrate; a second photo solder resist layer being stacked on at least one region of a lower portion of the first substrate; and a MEMS structure and a signal processing element being disposed on the first photo solder resist layer, wherein the first substrate is directly bonded to the first photo solder resist layer and the second photo solder resist layer.

In order to solve the above technical problem, a MEMS microphone according to yet another embodiment of a fourth embodiment of the present invention comprises: a first substrate; a second substrate being stacked on at least one region of the first substrate; a conductive adhesive layer being stacked between the first substrate and the second substrate; a MEMS structure and a signal processing element being disposed on the second substrate; and a cover covering the second substrate, wherein the second substrate includes a base facing the first substrate, and a side plate being extended upward from the outer perimeter of the base, and wherein the cover is bed to the end of the side plate of the second substrate.

In addition, the first substrate and the cover may be made of the same material.

In addition, the second substrate and the cover may be bonded by soldering.

In addition, the first substrate may include a 2METAL COF substrate.

In addition, the first substrate is a flexible substrate, and the second substrate may be a rigid substrate.

In addition, the second substrate may include any one among nickel silver, SUS, ceramic, and FR4.

In addition, it may include a capacitor being disposed in the second substrate and spaced apart from the signal processing element.

In addition, the signal processing element may include an ASIC module.

In order to solve the above technical problem, a MEMS microphone according to a fifth embodiment of the present invention comprises: a first substrate; a second substrate being stacked on at least one region of the first substrate; a shield can being bonded to the second substrate; and a MEMS structure and a signal processing element being disposed on the second substrate in an internal space of the shield can, wherein the shield can is made of the same material as the second substrate.

In addition, the second substrate and the shield can may be made of SUS or nickel silver.

In addition, the second substrate includes a seating portion on which the shield can is disposed in a region being bonded with the shield can, wherein the thickness of the seating portion of the second substrate may be thinner than the thickness of other regions of the second substrate other than the seating portion.

In addition, the shield may include an upper plate; a side plate being extended from an outer perimeter to a lower portion of the upper plate; and a lead portion being extended outward from the end of the side plate.

In addition, the shield can may include: an upper plate; a side plate being extended from an outer perimeter to a lower portion of the upper plate; and a plurality of protrusions being extended from the end to the lower portion of the side plate and spaced apart from each other.

In addition, the second substrate may not be stacked on a region corresponding to the protrusion of the shield can.

In addition, the second substrate may be etched in a region corresponding to the protrusion of the shield can, so that the end of the protrusion of the shield can may be bonded to the first substrate.

In addition, the side surface of the protrusion connecting the end of the side plate of the shield can and the end of the protrusion, and the end of the side plate of the shield can may be bonded to the second substrate.

In addition, epoxy or silicone that fills the steps of the shield can and the first substrate and the region where the shield can and the second substrate may be bonded together with the shield can.

In addition, the upper plate of the shield can has a square shape, the side plate of the shield can includes first to fourth side plates being extended from the upper plate, and the plurality of protrusions may be extended from an end of the side plate to a lower portion along the shape of an edge where two adjacent side plates among the first to fourth side plates are connected.

In order to solve the above technical problem, a MEMS microphone according to a fifth embodiment of the present invention comprises: a first substrate; a second substrate being stacked on at least one region of the first substrate; a housing being bonded to the second substrate; and a MEMS structure and a signal processing element disposed on the second substrate in the internal space of the housing, wherein the second substrate includes an etching region in which the MEMS structure or the signal processing element is disposed, and wherein the thickness of the etching region of the second substrate is thinner than the thickness of other regions of the second substrate other than the etching region.

In addition, when bonding the MEMS structure with the second substrate, epoxy or silicon may be applied inside the etching region.

In addition, the etched region of the second substrate may form a cavity as the surface facing the first substrate is etched.

In addition, a wire being electrically connected to the first substrate may be disposed in the cavity.

In addition, it may include a capacitor being disposed in an etched region of the second substrate and spaced apart from the signal processing element in the internal space of the housing.

In addition, the signal processing element may include an ASIC module.

In addition, the first substrate is a flexible substrate, and the second substrate may be a rigid substrate.

In addition, the first substrate and the second substrate can be bonded by thermal compression.

In order to solve the above technical challenges, a MEMS microphone according to another embodiment of the sixth embodiment of the present invention comprises: a first substrate; a second substrate being stacked on at least one region of the first substrate; a housing being bonded to the second substrate; and a MEMS structure and a signal processing element disposed on the second substrate in the internal space of the housing, wherein the second substrate is not stacked on a region where the MEMS structure or the signal processing element is disposed.

In addition, the second substrate is not stacked in the region where one of the MEMS structure or the signal processing element is disposed; the region where the other is disposed includes an etching region; and the thickness of the etching region of the second substrate may be thinner than the thickness of other regions of the second substrate other than the etching region.

### [Advantageous Effects]

According to embodiments of the present invention, the process can be simplified and the time can be shortened. In addition, the metal plate hole etching region can be reduced, so the process control point can be reduced, design freedom for hole shape and size reduction can be increased, the capacity of the capacitor can be increased, and the attachment area of the conductive adhesive layer can be increased, thereby preventing peeling and increasing reliability.

According to embodiments of the present invention, it is possible to mount a plurality of capacitors, so it is possible to mount capacitors for removing power noise and RF noise. Furthermore, capacitors to remove power noise for DVdd and power supply noise for AVdd can be installed, respectively.

According to embodiments of the present invention, audible noise due to capacitor mounting can be eliminated. The process can be simplified by manufacturing the capacitor as a separate element that can eliminate audible noise.

According to an embodiment of the present invention, MEMS stress can be improved and solder separation can be prevented by using a coverlay or PSR. In addition, the thickness of the substrate or cover can be reduced, ensuring SNR performance and lowering production costs.

According to an embodiment of the present invention, bonding reliability can be increased by bonding the shield can with a shield can made of the same material as the metal plate, or a lead type, non-lead type, or castle type.

According to an embodiment of the present invention, cavity securing and flip chip bonding are possible by variously applying half etching or full etching to the metal plate; by forming a cavity between the metal plate and the COF, securing of the degree of freedom of wiring of the 2-metal COF is possible; expanding of the degree of freedom to reflect design, such as minimizing the line loss and parasitic impedance becomes possible; and from this, SNR performance can be improved by minimizing the noise level.

### [Brief Description of Drawings]

FIG. 1 illustrates a MEMS microphone according to an embodiment of the present invention.
FIGS. 2 to 13 are diagrams for explaining a MEMS microphone according to a first embodiment of the present invention.
FIG. 14 illustrates a MEMS microphone according to a second embodiment of the present invention.
FIGS. 15 to 24 are diagrams for explaining a MEMS microphone according to a second embodiment of the present invention.
FIG. 25 illustrates a MEMS microphone according to a third embodiment of the present invention.
FIG. 26 is a diagram for explaining a MEMS microphone according to a third embodiment of the present invention.
FIG. 27 illustrates a MEMS microphone according to a fourth embodiment of the present invention.
FIGS. 28 to 37 are diagrams for explaining a MEMS microphone according to a fourth embodiment of the present invention.
FIG. 38 illustrates a MEMS microphone according to a fifth embodiment of the present invention.
FIGS. 39 to 46 are diagrams for explaining a MEMS microphone according to a fifth embodiment of the present invention.
FIG. 47 illustrates a MEMS microphone according to a sixth embodiment of the present invention.
FIGS. 48 to 52 are diagrams for explaining a MEMS microphone according to a sixth embodiment of the present invention.
FIGS. 53 and 54 are diagrams for explaining a MEMS microphone according to an embodiment different from FIGS. 38 to 41.
FIGS. 55 to 59 are diagrams for explaining a MEMS microphone according to an embodiment different from that of FIG. 1 and FIG. 52.

### [Specific Details for Implementing the Invention]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or arranged in "on (above)" or "below (under)" of each component, "on (above)" or "below (under)" means that it includes not only the case where the two components are directly in contact with, but also the case where one or more other components are formed or arranged between the two components. In addition, when expressed as "on (above)" or "below (under)", the meaning of not only an upward direction but also a downward direction with respect to one component may be included.

A modified embodiment according to the present embodiment may include some configurations of each embodiment and some configurations of other embodiments. That is, the modified embodiment may include one of the various embodiments, but some configurations may be omitted and some configurations of other corresponding embodiments may be included. Or, it could be the other way around. Features, structures, effects, and the like to be described in the embodiments are included in at least one embodiment and are not necessarily limited to only one embodiment. Furthermore, the features, structures, effects, and the like illustrated in each embodiment can be combined or modified and implemented in other embodiments by a person with ordinary knowledge in the field to which the embodiments belong. Therefore, contents related to such combinations and modifications should be interpreted as being included in the scope of the embodiments.

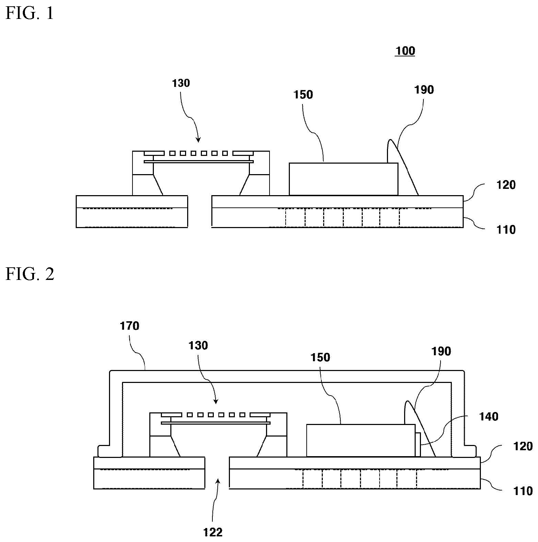

FIG. 1 illustrates a MEMS microphone according to an embodiment of the present invention, and FIGS. 2 to 13 are diagrams for explaining a MEMS microphone according to a first embodiment of the present invention.

The MEMS microphone **100** according to an embodiment of the present invention may comprise a first substrate **110**, a second substrate **120**, and a MEMS structure **130**, and includes a signal processing element **140** and a housing **170**.

A first substrate **110** is disposed in a lower portion of the MEMS microphone and has a plate shape. The first substrate **110** is a flexible substrate and may be a chip on film (COF) substrate or a flexible printed circuit substrate (FPCB). A COF substrate is a substrate formed by forming a circuit on a base film or mounting elements such as chips and has a film shape and is considerably thinner than other substrates. By using the COF substrate as the substrate for the MEMS microphone, the thickness can be significantly reduced. The first substrate **110** is a COF substrate and may be a 2-Metal COF substrate. 2-Metal COF is a substrate formed by forming a circuit or mounting elements on both sides of a base film.

Here, the first substrate **110** (for example, 2-Metal COF substrate) may be formed to have a thickness of 50 µm or more. Alternatively, it may be formed to have a thickness of 20 to 100 µm or more than 100 µm. However, it is not limited to the above thickness. By including via holes in the base film, circuits or elements being formed on both sides can be connected. Here, the via hole may be a micro via hole and may have a size of 25 µm or less. Compared to a single-sided COF, the degree of integration can be increased, the degree of freedom during packaging is improved, and a fine pitch is possible by placing circuits or elements on both sides. When using only a rigid substrate, it is not easy to apply fine pitch, but when using a COF substrate, fine pitch can be applied, allowing the size of the MEMS microphone package to be reduced by more than 50%. Flexible printed circuit substrate (FPCB) is a flexible circuit substrate, which is also flexible, and since its thickness is thinner than a general PCB, the thickness can be significantly reduced by using a flexible printed circuit substrate as a substrate for a MEMS microphone. In addition, other types of flexible substrates may be included. The first substrate **110** is electrically connected through the capacitor **150** and the wire **190**.

A second substrate **120** is stacked on the first substrate **110** and has a plate shape. The second substrate **120** is a rigid substrate and may be a metal plate, SUS, or a reinforcement plate. SUS is a steel grade mixed with iron and chromium to enhance corrosion resistance and is a high-strength substrate. In addition, various reinforcing plates made of metal can be used. In addition, it may include other types of rigid substrates that can be coupled with the housing to maintain the shield. The second substrate **120** is a substrate to supplement the rigidity of the first substrate **110**, and can maintain the flexible shape of the first substrate **110**.

The second substrate **120** includes one or more holes **121**. The second substrate **120** is located at an upper portion of the first substrate **110**, and a hole **121** is formed in the second substrate **120**, so that the first substrate **110** is connected to the second substrate **120** through the hole **121** so as to be exposed to an upper portion. The first substrate **110** may be electrically connected to the capacitor **150** being disposed at an upper portion of the second substrate **120** through the hole **121** being formed in the second substrate **120**.

A housing **170** forming an internal space may be disposed at an upper portion of the second substrate **120**. As shown in FIG. 2, the housing **170** is disposed at an upper portion of the MEMS microphone and may have a cover shape that covers the second substrate **120**. The housing **170** covers the second substrate **120**, thereby forming an internal space. The housing **170** may be a can type made of metal or may be made of various materials such as plastic. The housing **170** may be coupled with the second substrate **120**. At this time, the housing **170** and the second substrate **120** may be bonded by welding. The region where the housing **170** and the second substrate **120** are bonded may be bonded by micro welding. By bonding the housing **170** and the second substrate **120** by micro welding, the process of applying and curing can solder or epoxy is unnecessary, and solder line or epoxy application region is also unnecessary, so the size can be reduced by the corresponding area.

A MEMS structure **130** and a capacitor **150** may be disposed on the second substrate **120**, and a signal processing element **140** may be disposed as shown in FIG. 2. The MEMS structure **130** may be disposed within an internal space formed by the second substrate **120** and the housing **170**. The MEMS structure **130** includes a body, a back plate, and a vibration plate. A hole **122** may be formed in the first substrate **110** and the second substrate **120** at a position opposite to the lower portion of the MEMS structure **130**. The cross-sectional area of the hole **122** may be circular, but is not limited thereto. Here, the hole **122** may be an acoustic hole. The hole may be formed in a region of the housing **170** facing the upper portion of the MEMS structure **130**. In addition to being formed in the housing **170** region, the hole corresponds to the hole **122** in FIG. 2.

A hole **122** is formed in the first substrate **110** and the second substrate **120** or the housing **170**, and when the diaphragm vibrates due to sound pressure due to sound flowing in from the outside through the hole **122**, the acoustic signal can be detected by measuring the capacitance on the back plate. In FIGS. 1 and 2, the back plate is shown as being located at an upper portion of the diaphragm, but it is natural that the diaphragm may also be located at an upper portion of the back plate.

The signal detected by the MEMS structure **130** is transmitted to the signal processing element **140**. The MEMS structure **130** and the signal processing element **140** may be electrically connected. At this time, the MEMS structure **130** and the signal processing element **140** are connected to the wire **193** through wire bonding, and the signal detected from the MEMS structure **130** through the wire **193** may be transmitted to the signal processing element **140**.

The signal processing element **140** can process the electrical signal detected and transmitted from the MEMS structure **130**. The signal processing element **140** can amplify the signal detected by the MEMS structure **130**. Here, the signal processing element **140** may include, but is not limited to, an application-specific semiconductor integrated circuit (ASIC). The signal processing element **140** may be formed as a single module or may be formed in a chip form. The signal processing element **140** may include an ASIC and an EN-CAP for applying the ASIC.

The signal processing element **140** may be disposed on the second substrate **120**. At this time, the signal processing element **140** may be disposed on the second substrate **120** and spaced apart from the MEMS structure **130**. It is disposed together with the MEMS structure **130** in the internal space being formed by the second substrate **120** and the housing **170**, and can receive signals from the MEMS structure **130**. Since signal transmission between the MEMS structure **130** and the signal processing element **140** occurs in the internal space covered by the housing **170**, noise can be reduced. The signal processing element **140** may be electrically connected to the first substrate **110**. The signal processed in the signal processing element **140** is transmitted to the first substrate **110**, and may be transmitted through the first substrate **110** to an outside where the corresponding signal is needed.

A capacitor **150** may be disposed at an upper portion of the second substrate **120** along with a MEMS structure **130** and a signal processing element **140**. When the capacitor **150** is mounted, the signal-to-noise ratio is improved, and PSRR and PSR noise are also improved. In other words, noise-related performance such as SNR, PSRR, and PSR can be improved through the capacitor **150**. The capacitor **160** is electrically connected to the signal processing element **140** and can remove noise that may occur when processing signals in the signal processing element **140**.

PCBs other than COF, which is the first substrate **110**, have large via, land, pattern, clearance, wire-bonding pad size and clearance values, so there is no space to create an SMT solder pad on which capacitance elements can be mounted. On the other hand, when using a COF substrate, the capacitor **150** can be mounted together with the MEMS structure **130** and the signal processing element **140**.

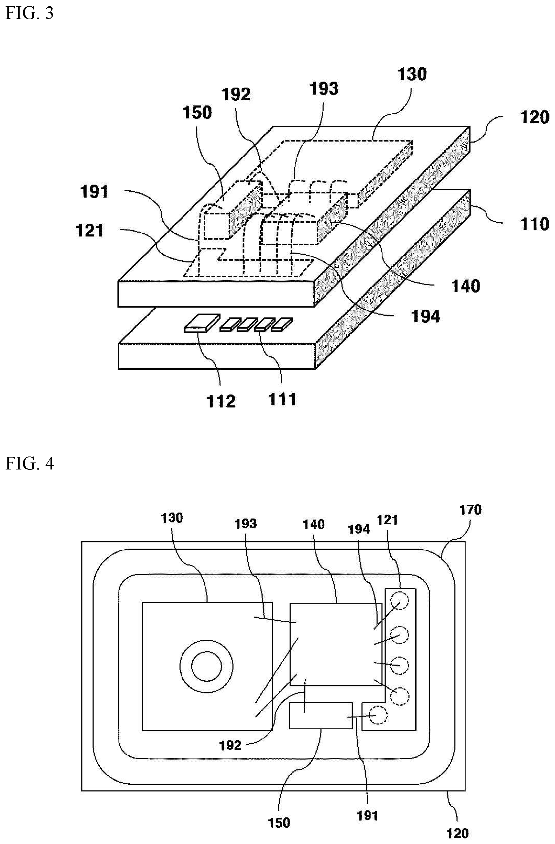

As shown in FIGS. 3 and 4, the capacitor **150** may be disposed at an upper portion of the second substrate **120** and electrically connected to the signal processing element **140** and the wire **192** through wire bonding. In addition, it may be electrically connected to the second substrate **120** through wire bonding of the wire **191** passing through the hole **121** being formed in the second substrate **120**. At this time, a wire pad **112** is formed in the first substrate **110** on the side being in contact with the second substrate **120**, and may be connected to the wire **192** being connected to the capacitor **150** through the wire pad **112**.

The capacitor **150** and the first substrate **110** may be connected through a wire **191**, and the capacitor **150** may be grounded through the wire **191**. Alternatively, signals can be exchanged with other components, modules, or external devices being connected to the first substrate **110**.

As shown in FIGS. 3 and 4, the signal processing element **140** receives signals from the MEMS structure **130** through the wire **193**, and it can be connected to the first substrate **110** through a wire **194** passing through the hole **121** being formed in the second substrate **120**. A wire pad **111** is formed in the first substrate **110** at a surface side where it is bonded to the second substrate **120**, and it can be connected to the wire **194** of the signal processing element **140** through the wire pad **111**.

The signal processing element **140** and the first substrate **110** are connected to the wire **194** through wire bonding, and the signal processed by the signal processing element **140** may be transmitted to the first substrate **110** through the wire **194**. In order to protect the wire bonding of the wires **193** and **194** of the signal processing element **140**, EN-CAP can be applied and dried at an upper portion of the signal processing element **140** to form a protective portion. Through this, the signal processing element **140** may not be exposed to the outside.

The signal transmitted to the first substrate **110** may be transmitted to the outside through a terminal being connected to the outside. At this time, since the terminal being connected to the outside must be exposed to the outside, not the internal space, it may be formed on a lower surface of the first substrate **110**. The signal processing element **140** is connected to the first substrate **110**, and since a terminal being connected to the outside may be formed at a lower portion of the first substrate **110**, a signal can be transmitted through a via hole connecting the upper portion and the lower portion of the first substrate **110**. When the first substrate **110** includes a plurality of layers, via hole may be formed to penetrate each layer.

Alternatively, the signal processing element **140** may be embedded inside the first substrate **110** or the second substrate **120**. In addition, the signal processing element **140** may be disposed on the first substrate **110**, and at this time, the second substrate **120** is not stacked at the location where the signal processing element **140** is disposed, or a hole corresponding to the shape of the signal processing element **140** may be formed.

When the signal processing element **140** is embedded inside the first substrate **110** and/or the second substrate **120**, at least a portion of the signal processing element **140** may be overlapped with at least a portion of the MEMS structure **130** in a first direction, which is the upper and lower direction of the first substrate **110**.

Alternatively, when the signal processing element **140** is embedded inside the first substrate **110** and/or the second substrate **120**, at least a portion of the signal processing element **140** may not be overlapped with at least a portion of the MEMS structure **130** in a first direction, which is the upper and lower direction of the first substrate **110**.

In the internal space where the first substrate **110** and/or the second substrate **120** and the housing **170** are formed, it is natural that other elements or modules, such as the capacitor **150**, may be disposed in addition to the EMS structure **130** and signal processing element **140**. Other devices or modules may also be embedded inside the first substrate **110** and/or the second substrate **120**. When other elements, such as the capacitor **150**, are embedded together with the signal processing element **140**, they can be embedded so that their positions are not overlapped with one another or are concentrated. Alternatively, other elements such as the capacitor **150** may be disposed in the second substrate **120** and only the signal processing element **140** may be embedded.

The capacitor **150** may be embedded inside the first substrate **110** and/or the second substrate **120**. In addition, the capacitor **150** may be disposed in the first substrate **110**, and at this time, the second substrate **120** may not be stacked at the location where the capacitor **150** is disposed, or a hole corresponding to the shape of the capacitor **150** may be formed.

When the capacitor **150** is embedded inside the first substrate **110** and/or the second substrate **120**, at least a portion of the capacitor **150** may be overlapped with at least a portion of the signal processing element **140** or at least a portion of the MEMS structure **130** in a first direction that is toward the upper portion of the first substrate **110**. The capacitor **150** includes a plurality of capacitors, and at least a portion of the at least one capacitor may be overlapped with at least a portion of the signal processing element **140** or at least a portion of the MEMS structure **130** in a first direction, which is the upper and lower direction of the first substrate **110**. By disposing the signal processing element **140** and the capacitor **150** close together, the capacitance increases, and through this, noise-related performance such as SNR, PSRR, and PSR can be improved.

Alternatively, when the capacitor **150** is embedded inside the first substrate **110** and/or the second substrate **120**, at least a portion of the capacitor **150** may not be overlapped with at least a portion of the signal processing element **140** or at least a portion of the MEMS structure **130** in a first direction, which is the upper and lower direction of the first substrate **110**.

Unlike the hole **122** being formed in a substrate region to face the lower portion of the MEMS structure **130**, the hole may be formed in the housing **170** to face the upper portion of the MEMS structure **130**. When a hole **122** is formed in the substrate region, there may be restrictions on the region of the substrate in which the signal processing element **140** is embedded depending on the location of the hole. However, when a hole is formed in the housing **170**, since a hole is not formed in the substrate region, when embedding the signal processing element **140** inside the substrate, restrictions due to holes may be eliminated. Therefore, more freedom in design is possible.

The signal processing element **140** may be bonded to the first substrate **110** by forming a flip chip BGA using a flip chip method. Additionally, the signal processing element **140** may be electrically connected to the wire pad of the first substrate **110** using a BGA method. The signal processing element **140** is disposed on a third substrate (not shown), which is an individual substrate of the signal processing element **140**, using a flip chip method, to form a flip chip BGA, and the flip chip BGA itself can be disposed on the first substrate **110** through ball grid array bonding. At this time, the signal of the MEMS structure **130** is transmitted to the first substrate **110** through a wire being connected to the first substrate **110** by wire bonding, and may be transmitted to the signal processing element **140** through the first substrate **110**.

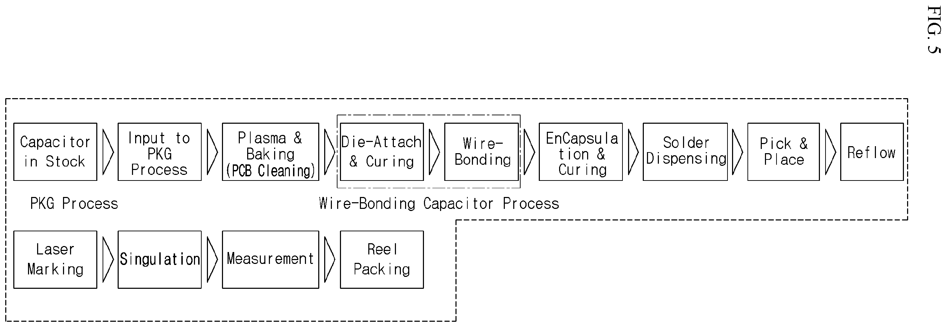

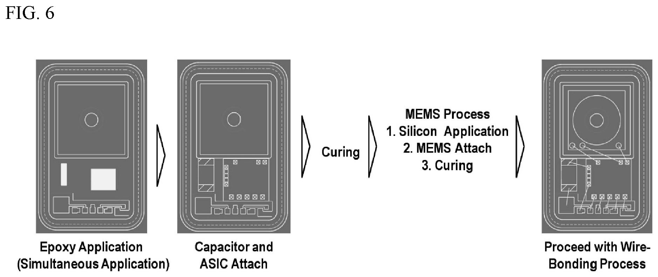

When the capacitor **150** is disposed on the second substrate **120** and connected to the first substrate **110** through wire bonding through the hole **121** passing through the second substrate **120**, the manufacturing process can be performed as shown in FIG. 5. Without any processing prior to the packaging process to dispose the capacitor on the substrate, when the capacitor **150** is received, it can be immediately put into the packaging process. After performing plasma and baking, the wire bonding process for the capacitor can be performed simultaneously during the processes of die-attachment, curing, and wire bonding. At this time, as shown in FIG. 6, epoxy is applied simultaneously to the required region, and after attaching the ASIC module, which is a capacitor and signal processing element **140**, a MEMS process consisting of curing the epoxy, applying silicone, attaching and curing the MEMS structure **130** is performed, and then a wire bonding process can be performed. After the wire bonding process, applying and curing EN-CAPSULATION, the process can be performed by solder discharge, component pickup and placement, reflow, laser work, singulation, measurement, and reel packing.

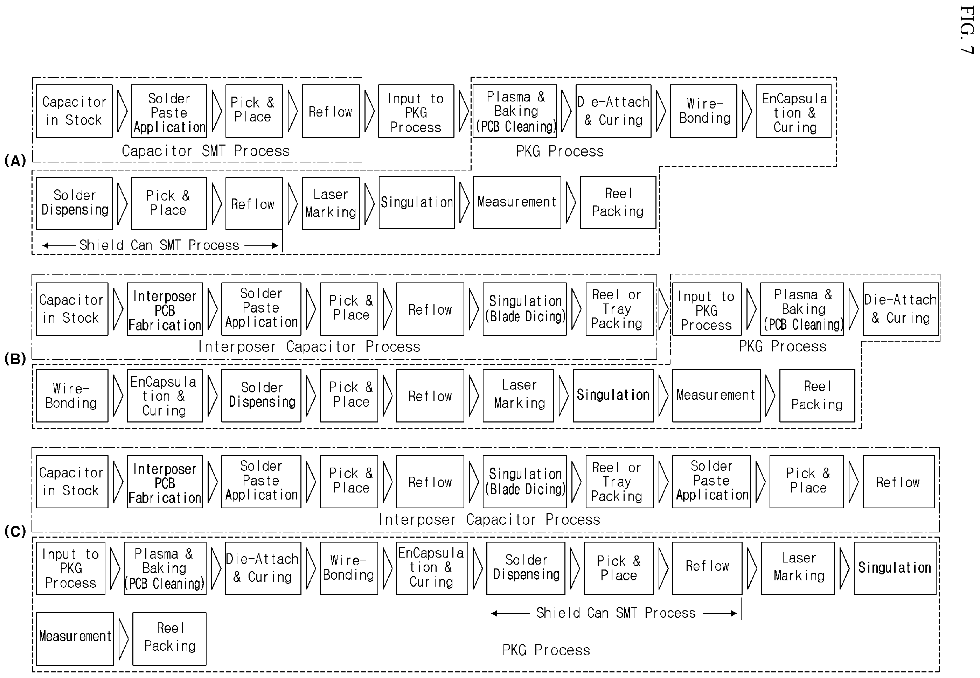

As in the comparative example of the present invention in FIG. 7, when the capacitor is mounted on the substrate using an SMT process (A) rather than wire bonding, or when the capacitor is mounted as a separate module (B, C), an additional process may be required in addition to the packaging process. In the case of mounting a capacitor (A), since application of EN-CAPSULATION is required on a capacitor that has been completed with SMT process, the surface mounting process cannot be performed on the capacitor in the surface mounting process of shield can, so a separate SMT process is required for the capacitor before entering the package process.

In addition, in the case of applying an interposer to the capacitor to configure a separate module (B, C), a separate process (interposer capacitor) is required to apply the interposer to the capacitor.

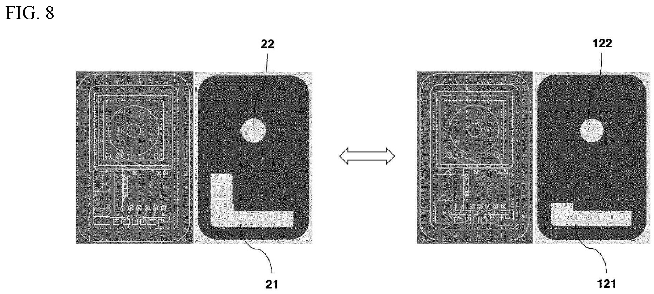

When mounting a capacitor with the SMT of FIG. 7(A) and electrically connecting the capacitor and the COF substrate corresponding to the first substrate, as shown in FIG. 8, the region of the hole **21** to be etched in the metal plate corresponding to the second substrate must be formed up to the capacitor mounting section. An acoustic hole **22** for the MEMS structure must also be formed in the metal plate. Since the region of the hole **21** etched corresponding to the capacitor is large, the design is limited.

On the other hand, in the embodiment of the present invention, since the capacitor **150** is electrically connected to the first substrate **110** through wire bonding, only the region through which the wire can pass is etched in the second substrate **120**. That is, as shown in FIG. 8, the region of the hole **121** of the first substrate **110** can be formed small. As the region to be etched is reduced, the process management points can be reduced after etching is completed, and the degree of design freedom to reduce the shape and size of the hole according to the applied structure increases.

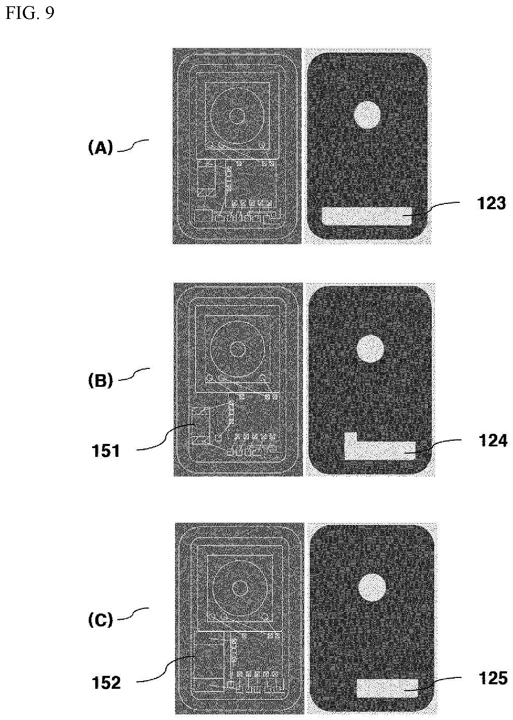

As shown in FIG. 9(A), the wires can be arranged on only one side of the second substrate to form a straight hole **123** on one side, and as shown in FIG. 9(B), by connecting a wire from the capacitor **151** to the signal processing element, the hole **124** may not be extended from one end to the other end, but may be formed only in a necessary region. As the region where the capacitor can be disposed on the second substrate **120** is expanded, the capacitor **152** with a larger size or capacitance can be applied, allowing greater freedom in selecting the capacitor. .

For example, in the case of SMT mounting in FIG. 8, a total of 8 wire bonding pads are required: 2 for capacitor SMT and 6 for ASIC wire bonding, which is a signal processing element. On the other hand, in an embodiment of the present invention in FIG. 8 and FIG. 9(A), a total of 7 pads are required, and in FIGS. 9(B) and 9(C), 6 pads are required. In addition, in the case of 9(C), the capacitor size (mm) may be 1.0 x 0.5 x 0.5, and in other cases, a capacitor size larger than the applicable capacitor size of 0.6 x 0.3 x 0.3 can be applied.

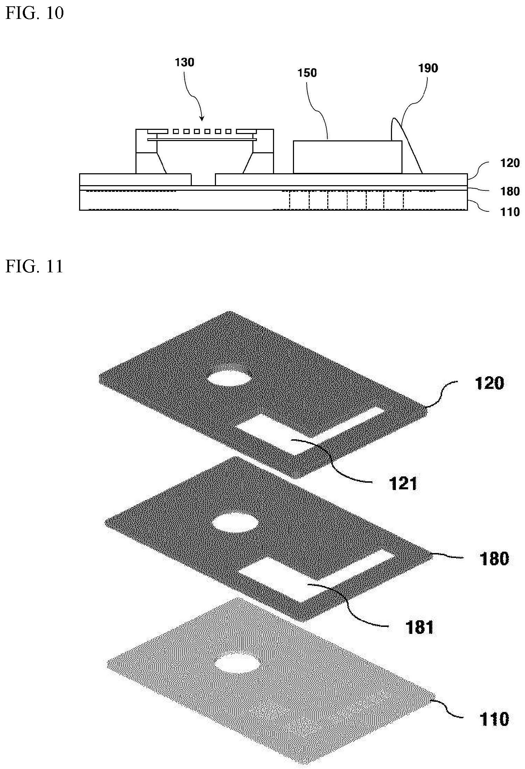

The second substrate **120** is stacked on the first substrate **110** and can be bonded by thermal compression. Alternatively, it may be bonded with conductive double-sided tape or the like. In addition, as shown in FIG. 10, a conductive adhesive layer **180** may be formed between the bonding surface of the first substrate **110** and the second substrate **120**. An adhesive may be applied to the conductive adhesive layer **180**, or a conductive double-sided tape may be disposed in the conductive adhesive layer **180**. The first substrate **110** and the second substrate **120** may be bonded in various ways to perform inter-substrate bonding. The conductive adhesive layer **180** may include a hole **181** being overlapped with the hole **121** of the second substrate **120**.

Here, the hole **121** of the second substrate **120** may be formed at a predetermined distance or more from the outer perimeter of the second substrate. When a hole is formed in the second substrate **120**, as shown in FIG. 11, the hole **181** must be formed in the conductive adhesive layer **180** in the corresponding region, thereby reducing the adhesive area. In addition, if the adhesive area is narrow depending on the shape of the hole, problems such as substrate peeling may occur due to weak adhesive strength. As described previously, in an embodiment of the present invention, since the area of the hole **121** is reduced or the degree of freedom in design is increased, adhesion force can be increased by forming holes in consideration of the adhesive area, and through this, attachment reliability can be improved. When the hole **121** is formed close to the outer perimeter of the second substrate **120**, that is, the conductive adhesive layer **180**, since problems may occur due to a small adhesive area in the outer perimeter area, when forming the hole **121**, it can be formed at a predetermined distance or more from the outer perimeter of the two substrates.

Here, the area of the hole **181** of the conductive adhesive layer **180** may be larger than the area of the hole **121** of the second substrate **120**. Because the resin of the adhesive of the conductive adhesive layer **180** may flow out during lamination, the area of the hole **181** of the conductive adhesive layer **180** may be formed to be larger than the area of the hole **121** of the second substrate **120**. For example, the area of the hole **181** of the conductive adhesive layer **180** may be formed to be 10 µm larger on one side than the area of the hole **121** of the second substrate **120**. Since the freedom of hole design is high, the area of the hole **181** of the conductive adhesive layer **180** is increased, so even though the adhesive area is reduced, the area of the hole **181** of the conductive adhesive layer **180** may be formed to be larger than the area of the hole **121** of the second substrate **120**.

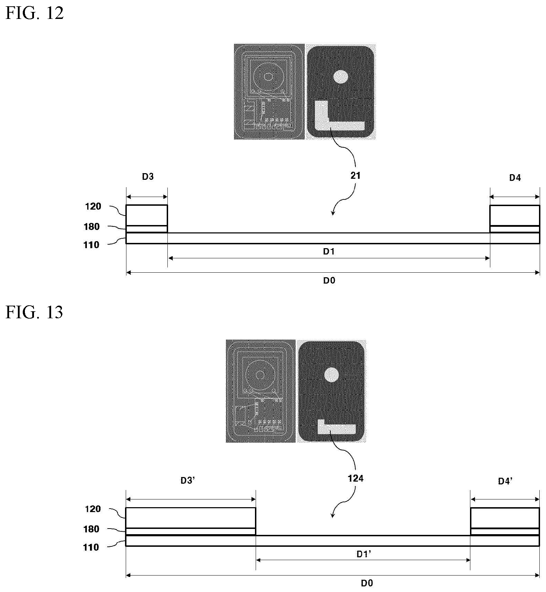

As shown in FIG. 12, when the hole **21** is formed up to the area being overlapped with the capacitor, both ends of the hole **21** become close to the outer perimeter of the conductive adhesive layer **180**. For example, as shown in FIG. 12, when the package width **D0** is 2 mm, the width **D1** of the etching area of the hole **21** is formed to be 1.53 mm, so the attachment widths of the first substrate **110** and the second substrate **120** by the conductive adhesive layer **180** being formed at both ends are only 0.23 mm for one end **D3** and 0.24 mm for the other end **D4**, and therefore, an extremely narrow section may occur, leading to a problem that peeling may occur after singulation.

On the other hand, as shown in FIG. 13, when the capacitor is connected by wire bonding, since the area of the hole **124** can be reduced compared to the hole **21** of FIG. 12, and the degree of freedom in design is also increased, both ends of the hole **124** may be formed to be spaced apart from the outer perimeter of the conductive adhesive layer **180** by a certain distance or more. For example, as shown in FIG. 13, when the package width **D0** is 2 mm, the width **D1'** of the etching area of the hole **124** can be formed as narrow as 1.13 mm, and through this, the attachment widths of the first substrate **110** and the second substrate **120** by the conductive adhesive layer **180** being formed at both ends can be widened to 0.55 mm at one end **D3'** and 0.32 mm at the other end **D4'**, so that the adhesive area increases, and through this, attachment reliability can be improved.

In addition, by placing the capacitor **150** at an upper portion of the second substrate **120**, which is a metal plate, the second substrate **120** may serve to prevent noise caused by sound due to microphone operation from being transmitted to the capacitor **150**. Through this, power supply rejection (PSR) performance can be prevented from deteriorating, and PSR can be improved.

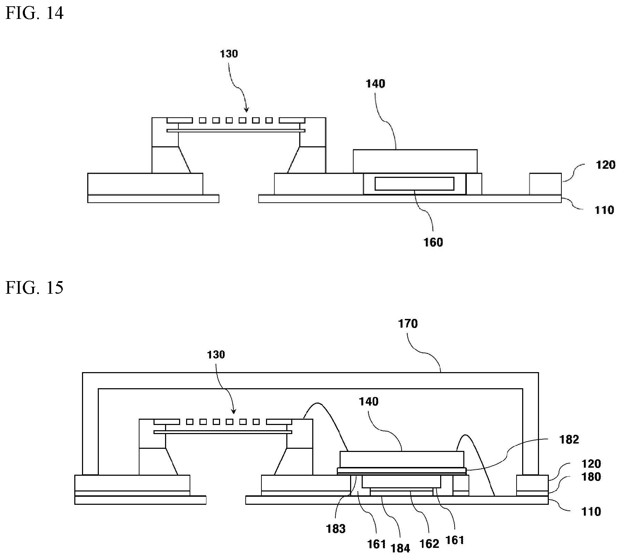

FIG. 14 illustrates a MEMS microphone according to a second embodiment of the present invention, and FIGS. 15 to 24 are diagrams for explaining a MEMS microphone according to a second embodiment of the present invention.

A MEMS microphone **200** according to a second embodiment of the present invention comprises a first substrate **110**, a second substrate **120**, a MEMS structure **130** being disposed on the second substrate **120**, and a signal processing element **140**, and one or more capacitors **150** and **160**. Among the detailed descriptions of the first substrate **110**, the second substrate **120**, the MEMS structure **130** being disposed on the second substrate **120**, and signal processing element **140**, overlapping descriptions corresponding to the detailed description of each configuration in FIGS. 1 to 13 will be omitted hereinafter.

The MEMS microphone according to an embodiment of the present invention may include a plurality of capacitors. The MEMS microphone may include a capacitor to remove noise, and at this time, it may include a capacitor for power noise filtering and a capacitor for RF noise filtering. For example, a capacitor for removing power noise may include a capacitor with a capacity of 0.1 µm to 10 µm, through which SNR performance can be improved. The capacitor for RF noise filtering may include one or two or more capacitors depending on the interference frequency, and at this time, each capacitor may include a capacitor with a capacity of 10 pF to 500 pF. Through this, SNR or PSRR performance can be improved. As MEMS microphones become smaller, there is not enough space to place capacitors, so it may not be possible to comply with the reference circuit and mount the capacitor, and as a result, SNR deterioration due to power noise and SNR and PSRR performance deterioration due to RF noise, and the like may occur. When placing a capacitor in a location away from the MEMS microphone, performance improvement is often minimal due to power noise and RF noise, and voltage may drop or signal quality may be deteriorated due to line loss.

A MEMS microphone according to an embodiment of the present invention can mount capacitors by applying a stack structure in which a capacitor with a relatively large capacity is disposed on the substrate, and a capacitor with a relatively small capacity is stacked with other components.

The capacitor may include a first capacitor **150** and a second capacitor **161**, and the first capacitor **150** may be disposed on the first substrate **110** on which the second substrate **120** is not stacked. At this time, the first capacitor **150** is disposed to be spaced apart from the MEMS structure **130** and the signal processing element **140**, and is electrically connected to the signal processing element **140** to transmit and receive signals. The second capacitor **161** may be stacked on a lower portion of the signal processing element **140**. The capacity or size of the first capacitor **150** may be larger than that of the second capacitor **161**. The first capacitor **150** may be a capacitor that performs power noise filtering, and the second capacitor **161** may be a capacitor that performs RF noise filtering.

The first electrode of the second capacitor **161** being stacked on a lower portion of the first substrate **110** is electrically connected to the first substrate, and the second electrode of the second capacitor **161** may be electrically connected to the second substrate **120**. Here, the first electrode of the second capacitor **161** may be an electrode being connected to a signal or power source, and the second electrode of the second capacitor **161** may be an electrode being connected to ground. The first electrode **162** of the second capacitor **161** may be disposed at a lower portion of the second capacitor and bonded to the first substrate **110** by soldering. At this time, a solder resist layer **184** may be included.

The signal processing element **140** may be connected to the MEMS structure **130** and the first substrate **110** through wires, respectively. When the second capacitor **161** is stacked at a lower portion of the signal processing element **140**, it may be difficult to electrically connect to the first substrate **110** at a lower portion of the signal processing element **140**, and the signal processing element **140** may be electrically connected to the first substrate **110** through wire bonding.

It may include a conductive adhesive layer **183** electrically connecting the second capacitor **161** and the second substrate **120** at an upper portion of the second capacitor **161**, and a non-conductive adhesive layer **182** being stacked between the conductive adhesive layer **183** and the signal processing element **140**.

The second substrate **120** may include an etching region in the region where the second capacitor **161** is disposed. Hole etching may be performed in the second substrate **120** to form a hole into which the second capacitor **161** can be mounted.

The first substrate **110** may include a 2-metal COF as a COF, and the second substrate **120** may include a metal plate. The MEMS microphone substrate, which is configured with a 2-metal COF and a metal plate, allows for a fine pitch design, making it possible to secure space for mounting multiple capacitors. At this time, the MLCC capacitor, which is the first capacitor **150**, and the silicon capacitor, which is an ultra-small capacitor, which is the second capacitor **161**, can be mounted together. Here, the multilayer ceramic capacitors (MLCC) can perform power noise filtering, and the silicon capacitor can perform RF noise filtering. The ultra-small capacitor is a silicon capacitor and may include a top electrode, which is a first electrode, and a bottom electrode, which is a second electrode, and each may be connected to a different node.

Hole etching of the second substrate **120** (for example, metal plate) with a thickness of 50 to 100 µm or more than 100 µm may be applied to secure a space for mounting the second capacitor **161**. The thickness of the second substrate **120** is not limited to the above thickness. Metal plate hole etching can be performed in a lower portion of the ASIC module, which is the signal processing element **140**, and a micro-capacitor, which is the second capacitor **161**, can be mounted in the hole etching region.

The size of the ultra-small capacitor is 0.5 x 0.5 (mm), the thickness may be 0.1 mm, or 0.5 x 0.25. If the capacitor size is different, the metal plate hole etching area can also be changed. The hole etching region is formed with an area of 0.65 x 0.65 mm, so that the edge of the hole etching region and the second capacitor **161** may be spaced apart by 75 µm. Since the second substrate **120** is GND, a separation distance from the second substrate **120** can be maintained for insulation.

The ultra-small capacitor, which is the second capacitor **161**, can be mounted through the packaging process comprising the steps of: mounting ultra-small capacitor SMT; applying UNDER-FILL; attaching conductive adhesive; applying non-conductive epoxy; and installing ASIC die. By attaching a conductive adhesive, the ground layer (GND layer) of the ultra-small capacitor, which is the second capacitor **161**, and the ground (GND) of the metal plate, which is the second substrate **120**, can be electrically conducted. In addition, conductive epoxy application and curing can be applied instead of attaching a conductive adhesive.

However, if the body of the ASIC die is GND, the non-conductive epoxy can be changed to a conductive epoxy after applying UNDER-FILL without attaching a conductive adhesive.

The second capacitor **161** may be stacked and disposed at a lower portion of the first capacitor **150** rather than at a lower portion of the signal processing element **140**. Forming a hole etching region by performing metal plate hole etching on the second substrate **120** at a lower portion of the first capacitor **150**, and the second capacitor **161** and the first capacitor **150** may be stacked and disposed.

The first electrode **153** of the first capacitor **150** is located on the second capacitor **161**, and the second electrode **154** of the first capacitor **150** may be located on the second substrate **120**. The first electrode of the second capacitor **161** is electrically connected to the first electrode **153** of the first capacitor **150**, and the second electrode of the second capacitor may be electrically connected to the first substrate **110**. The second substrate **120** may include an etching region in the region where the second capacitor **161** is disposed.

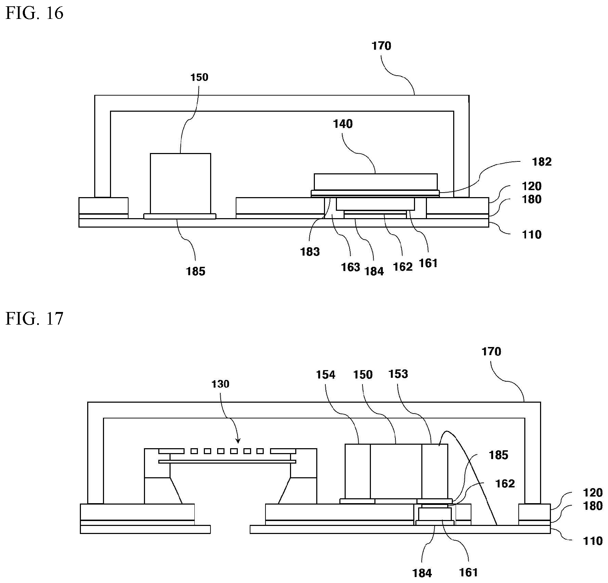

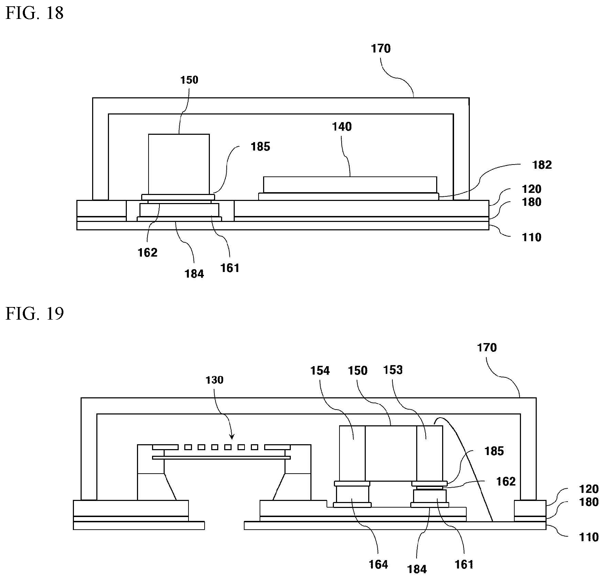

Here, the size of the second capacitor **161** being stacked in a lower portion of the first capacitor **150** may be smaller than the size of the first capacitor **150**, and hole etching may be performed on the region where the second capacitor **161** is stacked. That is, as shown in FIGS. 17 and 18, a portion of the first capacitor **150** is disposed at an upper portion of the second substrate **120**, another portion of the first capacitor **150** may be disposed at an upper portion of the second capacitor **161** being disposed in the hole etching region of the second substrate **120**.

The ultra-small capacitor, which is the second capacitor **161**, can be mounted through the packaging process comprising the steps of: SMT mounting of ultra-small capacitor; applying UNDER-FILL; applying solder paste or conductive epoxy; and reflow or curing. The subsequent process may be determined depending on the material applied during the solder paste or conductive epoxy application process. That is, reflow can be performed when applying a solder paste and curing can be performed when applying a conductive epoxy.

In addition, it includes a metal portion **164** being stacked on a lower portion of the first capacitor **150**, the first electrode **153** of the first capacitor **150** is located on the second capacitor **161**, and the second electrode **154** of the first capacitor **150** may be located on the metal portion **164**. Here, the first electrode **153** of the first capacitor **150** may be connected to the first substrate **110** with a wire.

The second substrate **120** includes a half-etched region where the metal portion **164** and the second capacitor **161** are disposed, and the thickness of the half-etched region may be thinner than the thickness of other regions.

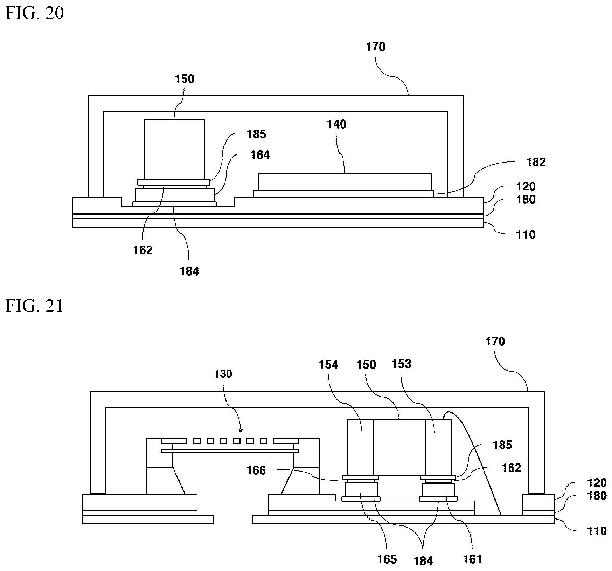

Unlike FIG. 17, where a part of the first capacitor **150** is stacked directly on the second substrate **120**, as shown in FIG. 19 and 20, the first electrode of both electrodes of the first capacitor **150** is located at an upper portion of the second capacitor **161**, and the second electrode may be located on the metal portion **164**.

In order to mount the second capacitor **161**, instead of applying metal plate hole etching, half-etching, which etches only a predetermined thickness out of the total thickness, is applied; in order to balance the height of the second capacitor **161** being disposed at the lower end of the signal electrode, which is the first electrode of the first capacitor **150**, and the height of the ground electrode, which is the second electrode, the metal piece, which is the metal portion **164**, can be seated on the lower end of the GND electrode, which is the second electrode of the first capacitor **150**. At this time, processes of applying of an epoxy (non-conductive), seating of the second capacitor **161** and metal part **164**, and curing are proceeded in the half-etched region of the metal plate, which is the second substrate **120**, for seating of the second capacitor **161** and the metal portion **164**; and for seating of the first capacitor which is the power noise removal capacitor, it can be mounted through the packaging process comprising the steps of: applying material; mounting the first capacitor; and reflow or curing depending on the type of the material being applied. The applied material may include solder paste, conductive epoxy, conductive adhesive, and the like; reflow is performed when applying a solder paste; and curing may be performed when applying conductive epoxy or conductive adhesive.

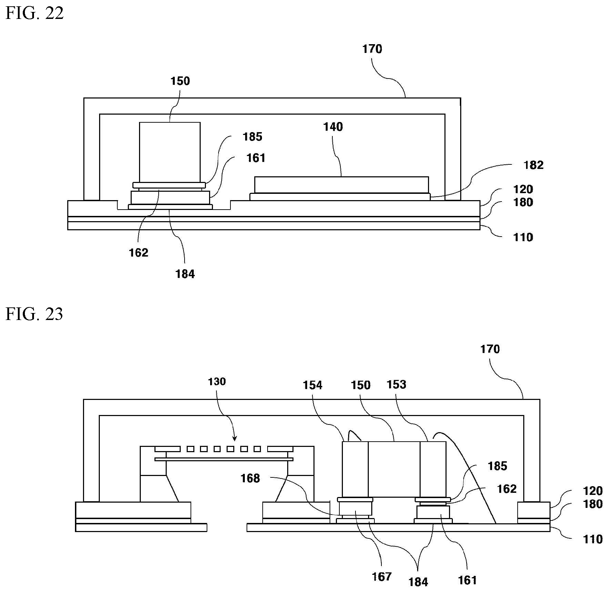

In addition, it may include a third capacitor **165** being stacked at a lower portion of the first capacitor **150**. That is, the third capacitor **165**, rather than the metal portion **164**, can be stacked on a lower portion of the first capacitor **150**. As shown in FIGS. 21 and 22, the first electrode **153** of the first capacitor **150** is located on the second capacitor **161**, and the second electrode **154** of the first capacitor **150** may be located on the third capacitor **165**. The first electrode **153** of the first capacitor **150** may be connected to the first substrate **110** with a wire, and the second electrode **154** of the first capacitor **150** may be electrically connected to the first electrode **166** of the third capacitor **165**.

The second substrate **120** includes a half-etched region where the second capacitor **161** and the third capacitor **165** are disposed, and the thickness of the half-etched region may be thinner than the thickness of other regions.

In order to maintain balance when the first capacitor **150** is seated, a third capacitor **165**, which is another capacitor instead of the metal portion **164**, may be applied. Here, the third capacitor **165** may be an ultra-small capacitor. The first electrode **153** of the third capacitor **165** may be connected, that is, in series, to the second electrode **154** of the first capacitor **150**. By applying the third capacitor **165**, it is possible to serve as a series capacitor being connected in series on an equivalent circuit. Through serial connection of the first capacitor **150** and the third capacitor **165**, various capacitor capacitances can be configured by combining the two capacitances. The process of mounting the third capacitor **165** corresponds to the process of mounting the second capacitor **161**.

It includes three capacitors: a first capacitor **150**; a second capacitor **161**; and a fourth capacitor **167**, wherein the second substrate **120** may be disposed on the first substrate **110** not being stacked. The first capacitor **150** is disposed on the first substrate **110** on which the second substrate **120** is not stacked; the second capacitor **161** is stacked on the lower portion of the first electrode **153** of the first capacitor **150**; the fourth capacitor **167** is stacked on the lower portion of the second electrode **154** of the first capacitor **150**; the first electrode of the second capacitor **161** is electrically connected to the first electrode **153** of the first capacitor **150**; the second electrode of the second capacitor **161** is electrically connected to the first substrate **110**; the first electrode of the fourth capacitor **167** is electrically connected to the first substrate **110**; and the second electrode of the fourth capacitor **167** may be electrically connected to the second electrode **154** of the first capacitor **150**. The first electrode **153** of the first capacitor **150** may be connected to the first substrate **110** with a wire.

Unlike in FIGS. 17 to 22 where at least a portion of the first capacitor **150** is disposed in the upper portion of the second substrate **120**, as shown in FIG. 23, the first capacitor **150**, the second capacitor **161**, and the fourth capacitor **167** may all be disposed on the first substrate **110** on which the second substrate **120** is not stacked. A hole etching region in which the second substrate **120** is not laminated is formed on the second substrate **120** through metal plate hole etching, and the first capacitor **150**, the second capacitor **161**, and the fourth capacitor **167** can be mounted in the hole etching region. At this time, unlike the third capacitor **165** of FIG. 21, the first electrode of the fourth capacitor **167** is electrically connected to the first substrate **110**, and the second electrode of the fourth capacitor **167** may be electrically connected to the second electrode **154** of the first capacitor **150**. Through this, the third capacitor **165** is not connected in series with the first capacitor **150** but in parallel. Alternatively, it is natural that they can be connected in reverse and connected in series.

The first electrode of the fourth capacitor **167** may be electrically connected to the AVDD pad being formed on a lower portion of the first substrate **110**. The second electrode of the second capacitor **161** may be electrically connected to the DVDD pad being formed on a lower portion of the first substrate **110**.

Here, the first capacitor **150** performs noise removal for DVDD power supply, and the fourth capacitor **167** may perform noise removal for AVDD power supply. In other words, each of the capacitor for removing power noise and the capacitor for removing RF noise in the path of DVDD side, and the capacitor for removing RF noise in the path of AVDD side, may perform different roles.

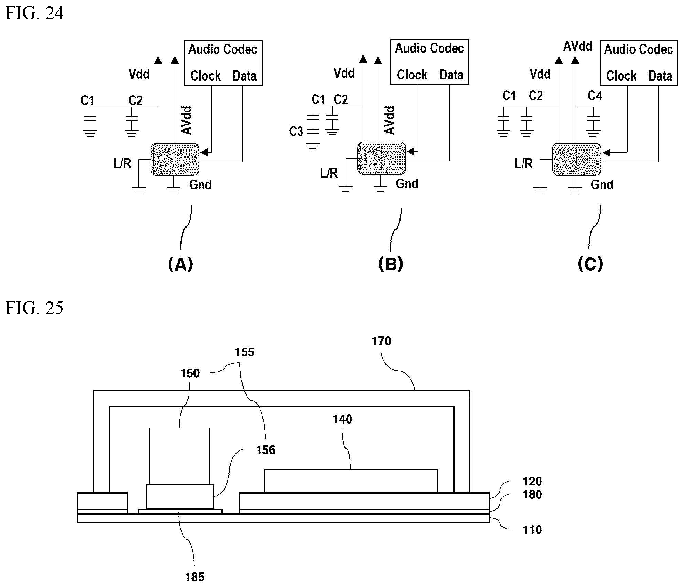

When including **C1**, which is the first capacitor **150**, and **C2**, which is the second capacitor **161**, a connection relationship can be configured as shown in FIG. 24(A); when including **C1** as the first capacitor **150**, **C2** as the second capacitor **161**, and **C3** as the third capacitor **165**, a connection relationship can be configured as shown in FIG. 24(B); and when **C1** is the first capacitor **150**, **C2** is the second capacitor **161**, and **C4** is the fourth capacitor **167**, a connection relationship can be configured as shown in FIG. 24(C). At this time, **C1** performs DMS power noise removal, **C2** performs RF noise removal, and **C3** is connected in series with **C1** to implement various capacitor capacitances. **C4** performs power noise removal, but **C1** can be configured for DVDD and **C4** can be configured for AVDD.

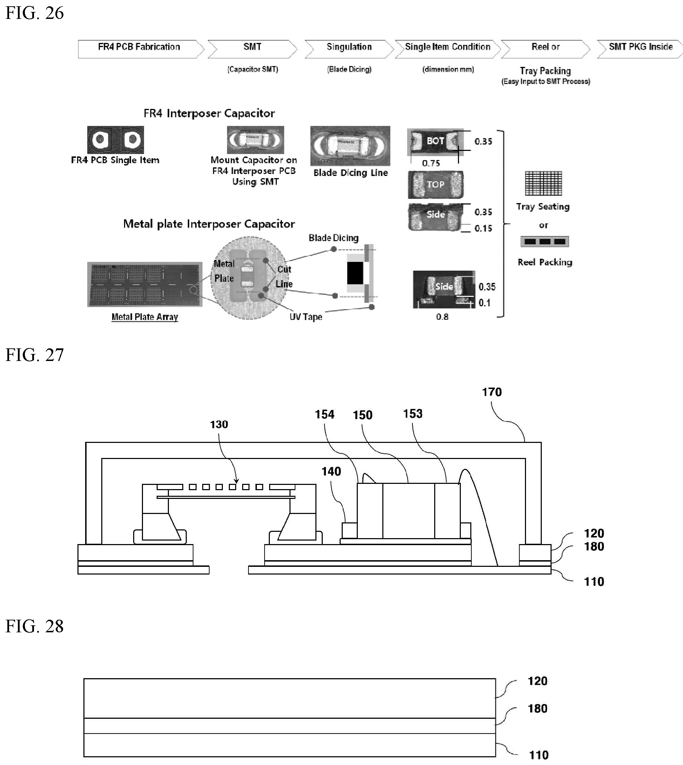

FIG. 25 illustrates a MEMS microphone according to a third embodiment of the present invention; and FIG. 26 is a diagram for explaining a MEMS microphone according to a third embodiment of the present invention.

A MEMS microphone according to an embodiment of the present invention comprises: a first substrate **110**; a second substrate **120** being stacked on at least one region of the first substrate **110**; a MEMS structure **130** being disposed on the second substrate **120**; a signal processing element **140**; and a capacitor element **155**. The capacitor element **155** includes a capacitor **150** and an interposer **156** being stacked on a lower portion of the capacitor **150**. The capacitor element **155** may be stacked on the first substrate **110** on which the second substrate **120** is not stacked. Among the detailed description of the first substrate **110**, the second substrate **120**, the MEMS structure **130** being disposed on the second substrate **120**, the signal processing element **140**, and the capacitor **150**, overlapping explanations corresponding to the detailed description of each configuration in FIGS. 1 to 24, will be omitted hereinafter.

The MEMS microphone according to an embodiment of the present invention uses a COF substrate and a metal plate to mount capacitor components inside the MEMS microphone, but side effects may occur from this. When AC bias is applied to a MEMS microphone with a capacitor element mounted inside, it has ferroelectric/multilayer-piezo/dielectric characteristics at the same time due to the characteristics of the MLCC capacitor, so deflection occurs according to the application of power (AC bias). In other words, when AC bias is applied, microscopic vibrations of several pm to several nm occur due to the expansion/contraction of the mounted capacitor, and as a result, the vibration may be transmitted to the substrate, resulting in audible noise due to the micro-vibration of the substrate. Due to this audible noise, power supply rejection (PSR) performance may be degraded.

The capacitor element **155** according to an embodiment of the present invention includes an interposer **156** in a lower portion of the capacitor **150** to remove audible noise. In other words, the capacitor is not mounted directly on the substrate, but is mounted on an interposer, which is a physical structure, and then mounted on the substrate, thereby absorbing interposer vibration and preventing audible noise.

The interposer **156** may be disposed between the capacitor **150** and the first substrate **110;** miniaturization is essential for the interposer capacitor applied inside the MEMS microphone; and the capacitor element **155,** which includes the interposer, also needs to be miniaturized so that its level becomes less than 0.6 mm × 0.3 mm × 0.35 mm, which is the size of the capacitor.

The capacitor size of the capacitor element **155** being mounted inside a package of 3 mm × 2 mm × 0.825 mm is 0.6 mm × 0.3 mm × 0.35T mm, and the size may be less than 0.9 mm × 0.4 mm × 0.194 mm.

The capacitor element **155** may be formed as one device component by mounting the capacitor **150** on an upper portion of the interposer **156.** The interposer **156** may include any one among an FR4 printed circuit substrate, a metal plate, a lead frame, a ceramic printed circuit substrate (ceramic PCB), and a metal printed circuit substrate (metal PCB).

Here, the interposer **156** includes an FR4 printed circuit substrate, and the capacitor **150** may be surface mounted on the printed circuit substrate to form one capacitor element.

In addition, the interposer **156** includes a metal plate, and the capacitor **150** may be mounted on the metal plate to form one capacitor element. Here, the metal plate includes a first metal plate and a second metal plate, and the first metal plate and the second metal plate may form a bridge structure respectively connected to both electrodes of the capacitor.

As shown in FIG. 26, an FR4 printed circuit substrate for the capacitor element is manufactured, the capacitor **150** is surface mounted (SMT), singulation is performed, the state of the individual product is inspected, reel or tray packing is performed, and it can be surface mounted on a substrate in a MEMS microphone packaging process.

When using a metal plate, the capacitor is mounted on the metal plate array. At this time, the metal plate includes a first metal plate and a second metal plate, and the first metal plate and the second metal plate may form a bridge structure that is respectively connected to both electrodes of the capacitor so that each is connected to a different node. Afterwards, singulation is performed, the state of the individual product is inspected, reel or tray packing is performed, and it can be surface mounted on the substrate in a MEMS microphone packaging process.

As described above, the capacitor element **155** formed as a single device component may be soldered onto the first substrate **110** on which the second substrate **120** is not laminated. At this time, metal plate hole etching may be performed on the second substrate **120** to form a hole etching region, and a capacitor element **155** may be disposed in the hole etching region.

The capacitor element **155** is arranged to be spaced apart from the signal processing element **140**, but may be electrically connected, and the signal processing element **140** may include an ASIC module. The first substrate **110** may be a flexible substrate, the second substrate **120** may be a rigid substrate, and the first substrate **110** and the second substrate **120** may be bonded through thermal compression.

FIG. 27 illustrates a MEMS microphone according to a fourth embodiment of the present invention; and FIGS. 28 to 37 are diagrams for explaining a MEMS microphone according to a fourth embodiment of the present invention.

A MEMS microphone according to an embodiment of the present invention comprises: a first substrate **110**; a MEMS structure **130**; and a signal processing element **140**. Among the detailed description of the first substrate **110**, MEMS structure **130**, signal processing element **140**, and capacitor **150**, overlapping explanations corresponding to the detailed description of each configuration in FIGS. 1 to 26 will be omitted hereinafter.

A MEMS microphone according to an embodiment of the present invention may include a first substrate **110** and a second substrate **120** being stacked on at least one region of the first substrate **110**. The first substrate **110** is a COF and may include a 2-metal COF, and the second substrate **120** may include a metal plate.

When using an FR4 rigid substrate, the FINE PITCH RULE cannot be applied, and there is a limit to lowering the thickness of the substrate. In contrast, a bonding structure of metal plate can be used by applying the fine pitch rule using 2-Metal COF, in which the bending problem is improved so that it can be served as a ground layer.

When bonding the first substrate **110** and the second substrate **120**, a conductive adhesive layer **180** can be used, as shown in FIGS. 27 and 28. The conductive adhesive layer **180** can be disposed between the first substrate **110** and the second substrate **120**, and the first substrate **110** and the second substrate **120** can be bonded through thermal compression bonding. First, the first substrate **110** and the conductive adhesive layer **180** are bonded by performing lamination, and the second substrate **120** can be bonded to the upper portion by performing lamination. Afterwards, the substrate can be formed through a hot press process. For example, lamination can be performed at 110 °C for 20 seconds, and the hot press process can be performed at 160°C, 60 min, and 20 kgf.cm.

The first substrate **110** and the second substrate **120** may be directly bonded without the conductive adhesive layer **180**. At this time, the SMT process or bonding process can be applied.

During the SMT process, solder is applied to the copper region of the 2-Metal COF layer, which is the first substrate **110**. The solder application region can be changed depending on the situation such as attachment reliability and metal plate rotation. After applying a solder, the metal plate that is the second substrate **120** can be seated, and reflow can be performed to bond the first substrate **110** and the second substrate **120**. The metal plate can be delivered in reel & tape type or tray type. The reflow process can change the profile depending on the specifications of the applied solder, COF and metal plate thermal equilibrium conditions, and the like.

During the bonding process, conductive epoxy is applied or a conductive die attachment film is attached to the copper region of the 2-Metal COF layer, which is the first substrate **110**. The epoxy application or die attachment film attachment region can be changed considering the flowability due to the viscosity of epoxy. Afterwards, the metal plate, which is the second substrate **120**, can be seated, and curing can be performed to bond the first substrate **110** and the second substrate **120**. The metal plate can be delivered in reel & tape type or tray type. In the curing process, curing conditions can be changed depending on the curing temperature and time conditions of the applied epoxy, die attach film, and the like.

An upper adhesive layer may be stacked on an upper portion of the first substrate **110** and the second substrate **120**. The upper adhesive layer may be stacked on an upper portion of the second substrate **120**, and the MEMS structure **130** and the signal processing element **140** may be disposed on an upper portion of the upper adhesive layer.

When the MEMS structure **130** is seated on the metal plate that is the second substrate **120**, the MEMS silicon may be over-cured due to high thermal conductivity, resulting in MEMS stress. When MEMS stress occurs, the initial sensitivity decreases and calibration is not possible, and SNR may decrease due to increased noise floor. This can be improved by stacking an upper adhesive layer on an upper portion of the second substrate **120**.

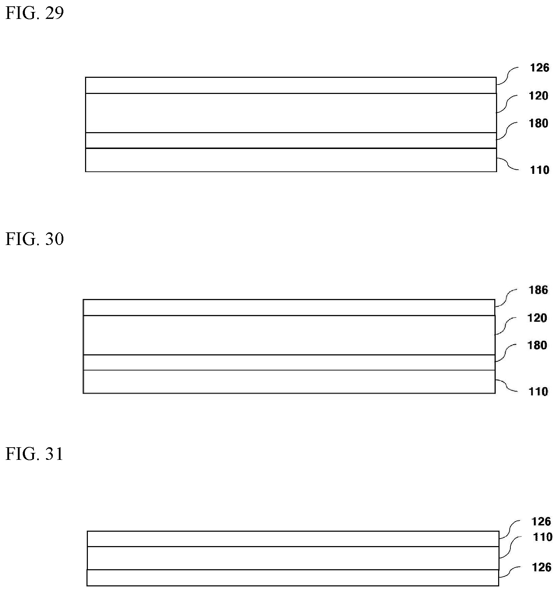

The upper adhesive layer may include a coverlay or photo solder resist (PSR). As shown in FIG. 29, the PSR **126** may be stacked on an upper portion of the second substrate **120**, or the coverlay **186** may be stacked as shown in FIG. **30**. The coverlay is a material made by applying semi-cured adhesive to polyimide (PI), and the thermal conductivity of PI is higher than that of nickel silver or SUS, which are materials for metal plates. The thermal conductivity of PI is 0.12 W/(m·K), the nickel silver plate is 45, and the SUS plate is 16.2, the nickel silver plate is 375 times higher than PI and the SUS plate is 135 times higher than PI.

Even if a coverlay or PSR is stacked, the thickness of the entire substrate is less than 0.21 mm based on the metal plate thickness of 100µm, so the entire substrate can be made thinner than when using the existing FR4 rigid substrate.

MEMS stress can be reduced by directly bonding the MEMS structure **130** to the upper adhesive layers. In addition, when applying solder when bonding the first substrate **110** and the second substrate, since during the reflow process, airtight shielding is not achieved due to lack of solder due to solder detachment, which may result in a decrease in SNR performance due to a leakage path. The coverlay and PSR act as a solder resist and can prevent solder separation.

The substrate can be formed using photo solder resist without stacking the metal plate that is the second substrate **120**. A first photo solder resist layer **126** and a second photo solder resist layer **126** may be included in an upper portion and a lower portion of the first substrate **110**, respectively. The second substrate **120** may be in direct contact with the first photo solder resist layer **126** and the second photo solder resist layer **126** to form one substrate.

As shown in FIG. 31, PSR can be stacked on an upper portion and a lower portion of the first substrate **110**. Since the thickness of the PSR is thinner than the metal plate, the thickness of the substrate can be reduced. In addition to the existing FR4 rigid PCB, the thickness can be lower than when applying a metal plate, and through this, SNR performance can be secured and the substrate manufacturing cost can be lowered.

For example, the PSR thickness of the first photo solder resist layer **126** and the second photo solder resist layer **126** can be varied from 20 µm to 55 µm, respectively. Here, the thickness can be changed in 5 µm units, allowing the thickness of the entire substrate to be adjusted.

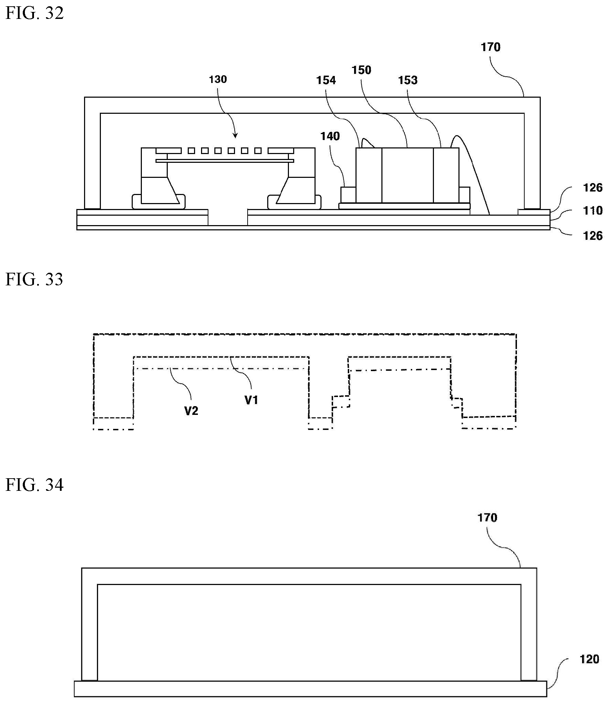

Through this, internal volume (back-volume) expansion is possible. It can be seen that the internal volume to which the metal plate of FIG. 27 is applied is **V1** in FIG. 33, and the internal volume of FIG. 32 to which the PSR **126** is applied is **V2** in FIG. 33, which increases the internal volume.

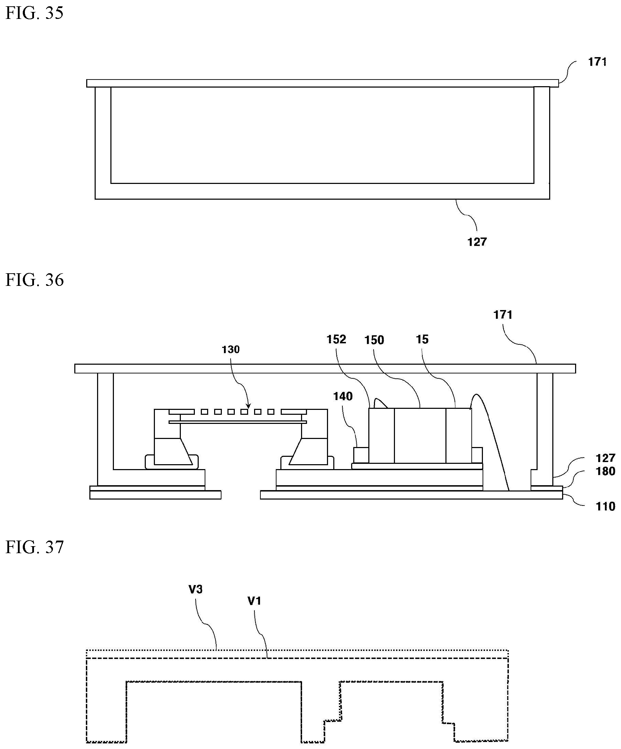

The metal plate, which is the second substrate, can be used to function as a housing rather than as a substrate. To this end, the second substrate is formed to include a base facing the first substrate **110** and a side plate being extended from the outer perimeter of the base to an upper portion as a second substrate **127 of** FIG. 35, and may include a cover **171** that covers the second substrate **127**. The cover **171** may be in contact with the end of the side plate of the second substrate **127**. The side plate may have a certain thickness, and the cover **171** may be in contact with an upper surface, which is the end of the upper end. The second substrate **127** and the cover **171** may be bonded by soldering. At this time, the first substrate **110** and the cover **171** may be made of the same material, the first substrate **110** and cover **171** may include a COF, and may contain 2-Metal COF.

In forming the shape of the second substrate **120**, a metal plate including a side plate is manufactured and bonded to the first substrate **110**, or a plate-shaped metal plate is used as the base and side plates, and it can be attached using eutectic bonding or conductive adhesive. At this time, there is an advantage of singulation. This metal plate can be used in a variety of ways, including nickel silver, SUS, lead frame, FR4, and the like.

As shown in FIG. 34, the second substrate **120** is formed in a plate shape, and unlike the housing **170** that covers the upper portion and is bonded to form an internal space, as shown in FIG. 35, an internal space may be formed using the second substrate **127** as a base and a side plate, and the cover **171** may cover the second substrate **127** to form an internal space. As shown in FIG. 36, a MEMS structure **130**, a signal processing element **140**, and the like may be disposed in the internal space.

By changing the shape of the metal plate, which is the second substrate, 2-Metal COF can be applied not only as the first substrate but also as a cover can at the same time. When 2-Metal COF is applied as a cover can, the internal volume (back-volume) can be expanded by reducing the thickness compared to the existing shield can. The internal volume where the metal plate in FIG. 34 is applied in a plate shape is **V1** in FIG. 37, and the internal volume of FIG. 35 in which the shape of the metal plate is changed and 2-Metal COF is used as a cover is **V3** in FIG. 37, it can be seen that the internal volume increases. Through this, cost reduction can be expected by utilizing 2-Metal COF compared to the cost of producing metal cover can. By using 2-Metal COF as a cover, the cost of the shield can is reduced, and when manufactured to the same specifications as the first substrate, since it can be manufactured with one type of COF, material management is easy and costs can be reduced.

The first substrate **110** is a flexible substrate; the second substrate **120** may be a rigid substrate; the second substrate **120** may include any one among nickel silver, SUS, ceramic, and FR4; it may include a capacitor being disposed on the second substrate **120** and spaced apart from the signal processing element **140**; and the signal processing element **140** may include an ASIC module.

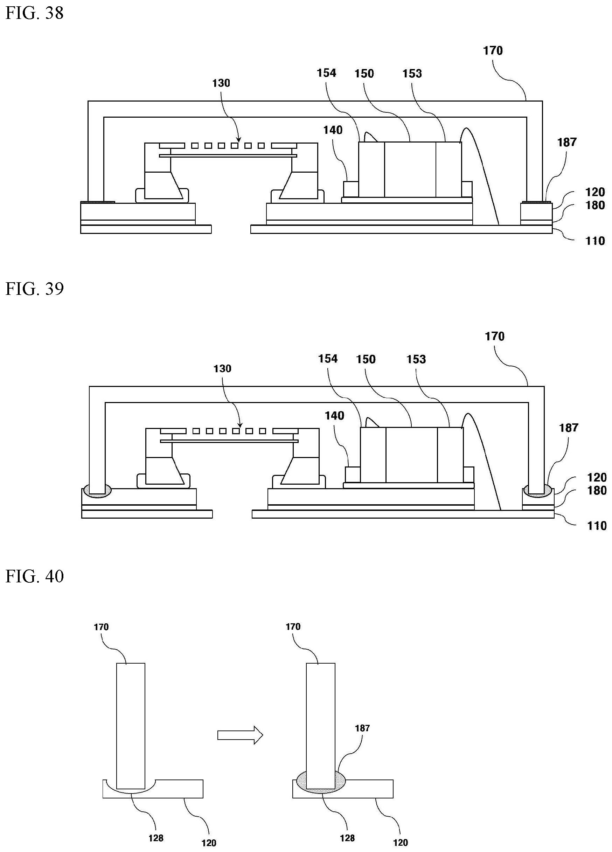

FIG. 38 illustrates a MEMS microphone according to a fifth embodiment of the present invention; and FIGS. 39 to 46 are diagrams for explaining a MEMS microphone according to a fifth embodiment of the present invention.

A MEMS microphone according to an embodiment of the present invention comprises: a first substrate **110**; a second substrate **120** being stacked on at least one region of the first substrate **110**; a housing **170**; a MEMS structure **130** being disposed on the second substrate **120**; and a signal processing element **140**. Among the detailed description of the first substrate **110**, a MEMS structure **130** being disposed on the second substrate **120**, a signal processing element **140**, and a capacitor **150**, overlapping explanations corresponding to the detailed description of each configuration in FIGS. 1 to 26 will be omitted hereinafter.

The housing of the MEMS microphone according to an embodiment of the present invention may be formed of a shield can. The shield can may be made of nickel silver or SUS. Hereinafter, when describing the MEMS microphone with reference to FIGS. 27 to 37, the housing will be described as a shield can **170**.

When applying a shield can to a MEMS microphone, when using a FR4 rigid PCB, solder is applied to the surface copper layer, the shield can is seated, and reflow process is proceed. At this time, via holes are formed in the surface copper layer, thereby reducing the area for applying solder to seat the shield can, and reliability due to problems such as occurrence of solder voids, rotation or tilting of shield can after reflow, deterioration of bonding adhesion force after bonding, and the like can be a problem.

The MEMS microphone according to an embodiment of the present invention improves the above problems by bonding a shield can to the metal plate, which is the second substrate **120**, thereby improving performance (SNR) and bonding reliability of shield can.

The shield can **170** is bonded on the second substrate **120**. As shown in FIG. 38, the shield can **170** can be bonded to the outer perimeter of the second substrate **120**. Here, the shield can **170** may be made of the same material as the second substrate. The second substrate **120** and the shield can **170** may be made of SUS or nickel silver and bonded thereto. The second substrate **120** and the shield can **170** can be bonded using solder **187**.

Nickel silver is a material containing 15 to 30% zinc and 10 to 20% nickel in copper, and can be soldered without plating in the raw material state. When plating is applied to the shield can **170** seating region, solder bonding adhesion force can be improved. Plating can be done using NI+AU plating. Both electroless and electrolytic plating processes can be applied.

Although SUS contains NI, solder bonding adhesion force may decrease if plating is not performed. Therefore, plating can be applied. Unlike nickel silver, plating adhesion force to the surface may decrease when electroless plating is applied, so plating is performed using an electrolytic plating process.

When the second substrate **120** and the shield can **170** that are bonded to each other are made of the same material, the heat diffusion index of the two components is the same, thereby improving bonding reliability. For example, if the second substrate **120** is a metal plate made of nickel silver, because thermal equilibrium is achieved, solder bonding is possible without gold plating, thereby improving bonding reliability.

In the case when the second substrate **120** is a SUS metal plate, since soldering is not possible to the SUS, which is a raw material, plating can be applied to the section where the shield can **170** is seated, and plating can also be applied to the shield can for thermal equilibrium.

When bonding the shield can **170**, the shield can **170** can be bonded to the second substrate **120** in various ways, such as a lead type, a non-lead type, and a castle type.

The lead type is a type in which the shield can legs are formed outside the shield can, and the bonding area between the substrate and the shield can leg portion is wide, which increases bonding reliability.

The non-lead type has no shield can legs in the form of a straight line coming down from the side wall, the external size of the shield can can be reduced by the leg portion of the shield. Through this, the package size can be reduced or the inner area can be increased based on the same package size. For example, the width of the lead section needs to be about 60 µm or more, while for the non-lead type the substrate size can be reduced by the lead width if the inner area is the same. In this case, the bonding area between the substrate and the shield can is reduced.

The castle wall type is based on the non-lead type structure, but the bridge section is formed in the shape of a castle wall. Various structural applications are possible with substrate structures such as metal plates.

The second substrate **120** may include a seating portion **128** on which the shield can **170** is disposed in a region that is bonded to the shield can **170**. FIGS. 39 and 40, the seating portion **128** may be formed in a region being bonded with the shield can **170**. The thickness of the seating portion **128** may be formed to be thinner than the thickness of other regions other than the seating portion. The seating portion **128** can be formed by etching the second substrate **120**. At this time, metal plate half-etching can be performed on the second substrate **120**; the shield can **170** is placed on the seating portion **128**; and soldering is performed using solder **187**; the area bonded to the second substrate **120** is expanded, thereby improving bonding strength; and hermetic shielding is possible. Through this, bonding reliability is improved, and improvement of SNR performance and improvement of tolerance become possible.

The shield can **170** may be formed in various shapes such as a lead type, non-lead type, and castle wall type. The shield can **170** is configured with an upper plate **172** and a side plate **173**, and it may include: a lead portion in the case of a lead type; a protrusion **174** in the case of a castle wall type.

It includes a plate-shaped upper plate **172** that serves as the base, a side plate **173** being extended from the outer perimeter of the upper plate **172** to a lower portion. In the case of the non-lead type, the end of the side plate **173** is formed in the form of a surface that bonds the second substrate **120** rather than in the form of a lead or a castle wall.

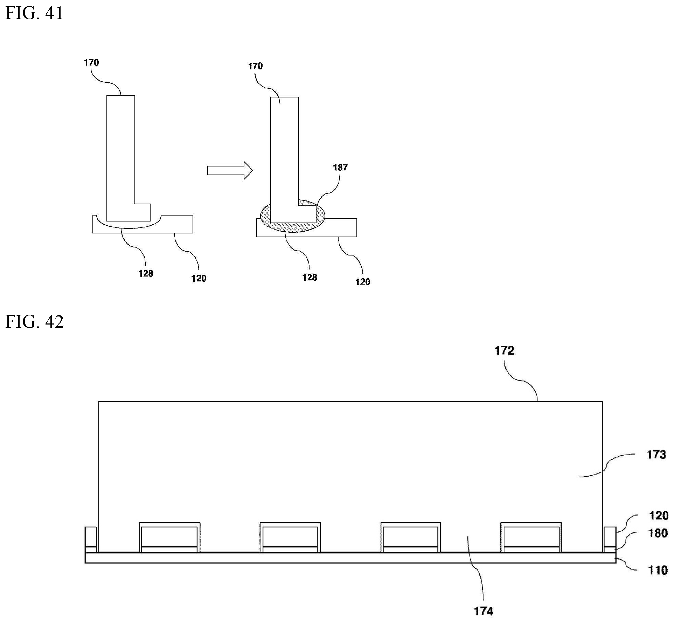

In the case of the lead type, the shield can **170** may include a lead portion being extended outward from the end of the side plate **173**. The lead portion is formed at the end of the side plate **173**, perpendicular to the lower direction, and being extended in an outward direction. It may be extended outward at a predetermined angle other than perpendicular to the lower direction, or may be extended in a curved shape. The lead portion may be formed to be extended inward rather than outward, and may have various shapes to expand the bonding area. The seating portion **128** of the second substrate **120** may be formed to correspond to the shape of the lead portion. As shown in FIG. 41, a seating portion **128** is included in the region corresponding to the lead portion, and can be bonded through solder **187**.

In the case of the castle wall type, the shield can **170** is extended from the end of the side plate **173** to the lower portion and may include a plurality of protrusions **174** being spaced apart from one another. The protrusions **174** may be formed to be spaced apart at predetermined intervals along the side plate **173**, as shown in FIG. 42.

The second substrate **120** may not be stacked in a region corresponding to the protrusion **174** of the shield can **170**. In the region corresponding to the protrusion **174** of the shield can **170**, the second substrate **120** is etched so that the end of the protrusion **174** of the shield can **170** can be bonded to the first substrate **110**. That is, the end of the side plate **173** on which the protrusion **174** of the shield can **170** is not formed is bonded to the second substrate **120**, and the protrusion **174** of the shield can **170** may be bonded to the first substrate **110**.

The region of the second substrate **120** that is bonded to the end of the shield can **170** may also be formed to be thinner than other regions by half-etching.

The side surface of the protrusion **174** connecting the end of the side plate **173** of the shield can **170** and the end of the protrusion **174**, and the end of the side plate of the shield can **170** can be bonded to the second substrate **120**. When a conductive adhesive layer **180** is included between the first substrate **110** and the second substrate **120**, the side surface of the protrusion **174** may be bonded to the second substrate **120** and the conductive adhesive layer **180**. That is, compared to the non-lead type in which only the ends of the side plates **173** are bonded, the bonding area can be increased and the bonding strength can be improved.

Metal plate full etching or half etching is applied to the second substrate **120**, and a shield can is formed in a castle wall type including protrusions **174**, allowing for more solid and deep seating. In the joint region where the protrusion **174** of the shield can **170** is formed, the seating surface of the shield can **170** and the upper copper of the 2-Metal COF, which is the first substrate **110**, are bonded, and in the section where the protrusion **174** is not formed, the side surface of the metal plate and the surface layer region are bonded. When the second substrate **120** is a nickel silver metal plate, a separate plating process for bonding may not be necessary; and in case of SUS, a plating process may be applied. Even in the case of nickel silver, plating can be applied to increase solder bonding adhesion force.

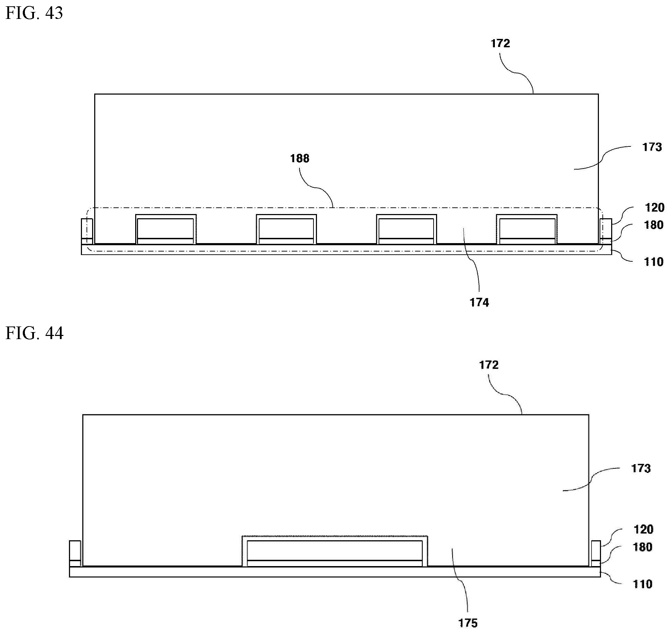

Epoxy or silicone filling the step of the region where the shield can **170** and the first substrate **110**, and the shield can **170** and the second substrate **120** may be bonded together with the shield can **170**. As shown in FIG. 43, when the shield can **170**, which has the same shape as a castle wall, and the second substrate **120** are bonded, a step section may exist, so it can be bonded together with a material **188** for sealing the shield can. In addition, the section where the protrusion is formed is bonded with a material for close contact with an upper layer copper pad of the first substrate **110** and the shield can, thereby increasing the bonding area and increasing the bonding reliability and sealing tightness of the shield can.

The material **188** for adhesion to the shield can may include at least one among solder paste, silver epoxy, conductive epoxy, and silicon. The solder paste is reflowed as a post-process; in the case when the metal plate is nickel silver, it can be applied regardless of plating; and in case of SUS, plating may be required. Silver epoxy requires oven cure as a post-process, and if the metal plate is nickel silver or silver, it can be applied without plating. Conductive epoxy and silicone undergo oven cure, and if the metal plate is nickel silver or silver, it can be applied for all of them without plating.

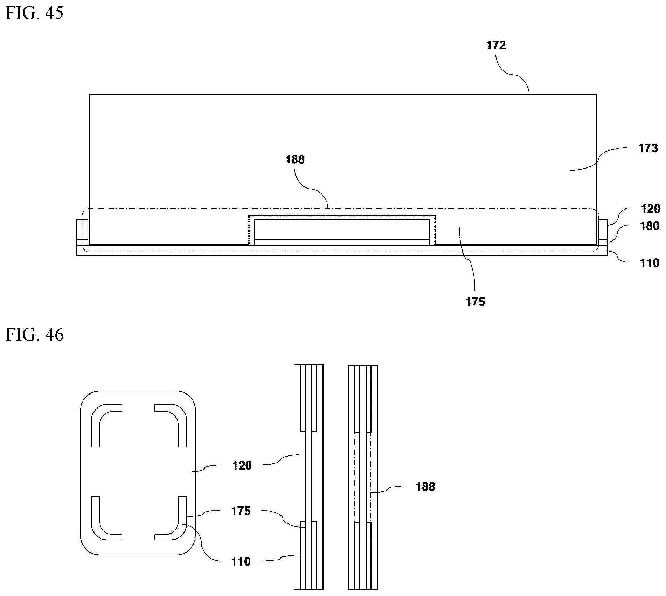

When the protrusion is formed in the corner region of the second substrate 120, the shield can can be bonded more firmly. The upper plate **172** of the shield can **170** has a square shape; the side plate **173** of the shield can **170** includes first to fourth side plates being extended from the upper plate; and the plurality of protrusions **175** may be formed by extending from the end of the side plate to the lower portion along the shape of the edge where two neighboring side plates of the first to fourth side plates are connected. As shown in FIGS. 44 and 46, the protrusion may include four protrusions **175** being formed in the corner region, and the four protrusions **175** may be formed across two neighboring side plates in the corner region, respectively. Epoxy or silicone **188** filling the step of the region where the shield can **170** and the first substrate **110**, and the shield can **170** and the second substrate **120** are bonded can be bonded together with the shield can **170**. As shown in FIG. 45, the materials **188** for adhesion to the shield can can be bonded together.

Full metal plate etching is performed on the second substrate **120** to correspond to the shape of the protrusion **175** so that a dam to dam bridge structure is formed; and by seating the protrusion **175** between dam to dam, bonding reliability and airtightness can be improved, and rotation of the shield can after reflow can be prevented.

Full etching is applied to the second substrate **120** so that the leg portion, which is a protrusion of the shield can **170**, can be seated between dams, and a bridge structure can be applied between dams. A bridge structure may be applied to prevent the second substrate **120** from being separated into two. The copper pad of the 2-Metal COF, which is the first substrate **110**, may be exposed in the fully etched region where there is no bridge structure between the dams.

The metal plate, which is the second substrate **120** applied with the bridge plus dam to dam structure, and the 2-Metal COF, which is the first substrate **110**, can be bonded with a conductive adhesive layer **180**, and a material **188** for adhesion to the shield can may be bonded together. The material **188** for adhesion to the shield can may include at least one among solder paste, silver epoxy, conductive epoxy, and silicon.

After applying the material **188** for adhering the shield can and mounting (pick & place) the shield can so that the protrusion **175** of the shield can is inserted between the dams, reflow or oven cure (depending on the bonding material) reflow (solder), oven cure (epoxy, silicon, AG epoxy, and the like) processes can be proceeded.

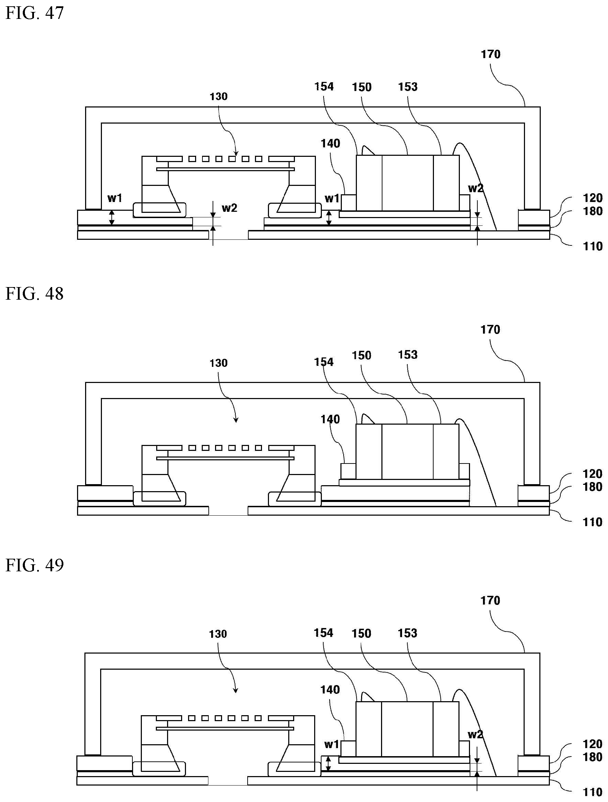

FIG. 47 illustrates a MEMS microphone according to a sixth embodiment of the present invention; and FIGS. 48 to 52 are diagrams for explaining a MEMS microphone according to a sixth embodiment of the present invention.

A MEMS microphone according to an embodiment of the present invention comprises: a first substrate **110**; a second substrate **120** being stacked on at least one region of the first substrate **110**; a housing **170**; a MEMS structure **130** being disposed on the second substrate **120**; and a signal processing element **140**. Among the detailed description of the first substrate **110**, a MEMS structure **130** being disposed on the second substrate **120**, and a signal processing element **140**, overlapping explanations corresponding to the detailed description of each configuration in FIGS. 1 to 46 will be omitted hereinafter.

In the case of FR4 rigid substrate, an increase in cost is inevitable for applying a cavity substrate. In addition, due to the design rule space such as line-space, clearance, and via, the region where the cavity can be applied is limited. In the case of flip-chip bonding, it is necessary to apply it to the surface of the FR4 rigid substrate upper layer, which inevitably increases the thickness and reduces the internal volume. The thickness can be reduced through embedding of the MEMS and ASIC, however, re-design layer (RDL) process of MEMS and ASIC is required. Since high-specification processes are required for embedding them inside the PCB, cost increase is inevitable.

The MEMS microphone according to an embodiment of the present invention can implement various cavity structures through the etching of the second substrate **120**.

The second substrate **120** includes an etching region where the MEMS structure **130** or the signal processing element **140** is disposed, and the thickness of the etching region is formed to be thinner than the thickness of other regions other than the etching region. It may include a capacitor **150** being disposed in the etching region of the second substrate **120** and spaced apart from the signal processing element **140** in an internal space of the housing **170**. The signal processing element **140** may include an ASIC module.

A cavity can be secured by applying half-etching that etches a portion of the second substrate **120** to the region where the MEMS structure **130**, signal processing element **140**, or capacitor **150** is disposed. As shown in FIG. 47, the thickness of the half-etched region, **W2**, can be formed to be thinner than the thickness of the other region, **W1**, to form a cavity. The thickness at which half-etching is performed may vary depending on the thickness of the metal plate that is the second substrate **120**.

For example, when half-etching is applied to a metal plate with a thickness of 0.1 mm, it can be etched to 0.05 mm. If the metal plate thickness is 0.2 mm, it can be disposed to be 0.1 mm when half-etching is applied. It goes without saying that it can be etched thicker or thinner than half the thickness. Through this, it is possible to improve the internal volume based on the same package size.

When bonding the MEMS structure **130** to the second substrate **120**, epoxy or silicon may be applied within the etched region. The half-etched region can be a guideline for applying silicon (for MEMS die mounting) or epoxy (for silicon die mounting), and can suppress the flow of silicon or epoxy before curing. Silicon may be applied to the etching region of the region corresponding to the MEMS structure **130**, and epoxy may be applied to the etching region of the region corresponding to the signal processing element **140** or the capacitor **150**. The un-etched region of the second substrate **120** between the two regions can also serve as a dam to prevent mixing of silicon and epoxy.

The second substrate **120** may not be stacked in a region where the MEMS structure **130** or the signal processing element **140** is disposed. A cavity can be secured using not only half etching but also hole etching that forms a hole. The second substrate **120** can be removed by hole-etching the second substrate **120** in the region where the MEMS structure **130** or the signal processing element **140** is disposed. Hole etching removes all of the second substrate to form a hole, so it can be refer to as a full etching.

Etching may be applied to only a portion of the region where the MEMS structure **130**, signal processing element **140**, and capacitor **150** are disposed.

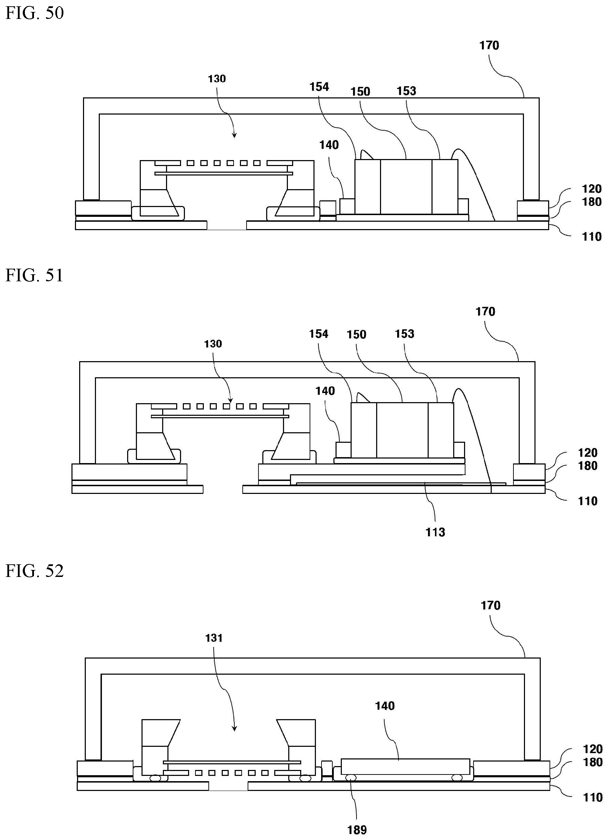

As shown in FIG. 48, full etching may be applied to the region of the MEMS structure **130**, and no etching may be applied to the region of the signal processing element **140** or capacitor **150**. As shown in FIG. 49, full etching can be applied to the region of the MEMS structure **130**, and half etching can be applied to the region of the signal processing element **140** or capacitor **150**. As shown in FIG. 50, full etching can be applied to all the regions of the MEMS structure **130**, signal processing element **140**, and capacitor **150**.

Cavities can be secured by applying full etching and half etching in various ways. Through this, it is possible to improve the internal volume based on the same package size; the full-etch and half-etch regions can serve as a guideline for applying silicon (for MEMS die mounting) and epoxy (for silicon die mounting); and the flow of silicone or epoxy before curing can be suppressed. Silicon may be applied to the etching region of the region corresponding to the MEMS structure **130**, and epoxy may be applied to the etching region of the region corresponding to the signal processing element **140** or the capacitor **150**. The region of the un-etched second substrate **120** between the two regions can also serve as a dam to prevent mixing of silicon and epoxy.

The etched region of the second substrate **120** may be etched on the surface facing the first substrate **110** to form a cavity. As shown in FIG. 51, when etching is applied to the second substrate **120**, the etching can be applied to a lower portion of the second substrate **120**, not an upper portion of the second substrate **120**, that is, etching can be applied to the surface facing the first substrate **110**. An internal cavity space covered with the second substrate **120** may be formed. A wiring being electrically connected to the first substrate **110** may be disposed in the cavity.

It is possible to secure the wiring freedom of 2-Metal COF by applying half etching, instead of the upper surface of the second substrate **120**, toward the lower surface, that is, toward the 2-Metal COF, which is the first substrate **110**. As the 2-Metal COF wiring freedom is secured, it is possible to expand the freedom of design reflection such as minimizing line loss and parasitic impedance, and from this, SNR performance can be improved by minimizing noise level.

In addition, it is possible to secure 2-Metal COF wiring freedom while maintaining the existing package structure, and by securing wiring freedom, ASIC and MLCC capacitor arrangement can be changed and expanded in a narrow space.

Full etching or half etching may be applied to the second substrate **120** and, at the same time, flip chip bonding of the MEMS structure **130** or signal processing element **140** may be applied. As shown in 52, flip chip bonding is possible in which the MEMS structure **130** or the signal processing element **140** using solder **189** is directly bonded to the first substrate **110**, and the MEMS structure **130** can be turned upside down for flip chip bonding.

Through this, internal volume can be expanded and SNR can be improved. By performing flip chip bonding, the wire bonding lines are eliminated, as ASIC and 2-Metal COF signal line are directly connected to reduce signal loss and improve impedance. In addition, the wire bonding process can be deleted. In the case of FR4 rigid PCB, embedded MEMS and ASIC are required for the same effect, and from this, an increase in substrate cost is inevitable, however, by simply expanding the etching region, substrate costs can be reduced while applying embedded MEMS and ASIC effects.

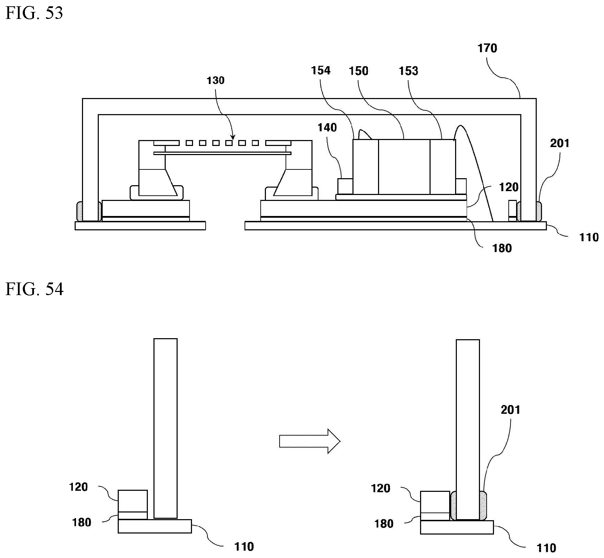

As shown in FIG. 38, the housing **170** is bonded onto the second substrate **120**, or as shown in FIG. 39, half-etching is performed on the second substrate **120** in order to form the seating portion **128**; and instead of bonding the housing **170**, as shown in FIGS. 53 and 54, a cover can, which is a housing **170,** can be mounted on the first substrate **110** rather than the second substrate **120**. At this time, the housing **170** can be surface mounted (SMT) on the electrode pad (copper pad) of the 2-metal COF, which is the first substrate **110**. The housing **170** is located on an outer perimeter of the second substrate **120**, so its position can be guided and fixed. After seating the housing **170**, it can be bonded using solder **201**.

Compared to the case where the housing **170** is bonded to the second substrate **120** through half-etching, the overlapping length of the housing **170** and the second substrate **120** may be increased. For example, in the case of half-etching, it is 50 µm, whereas in the case of the embodiment of FIGS. 53 and 54, it can be as long as 100 µm. Through this, the adhesion area of the solder **201** is expanded to improve airtight shielding, thereby improving SNR sensitivity changes or performance degradation due to air leakage.

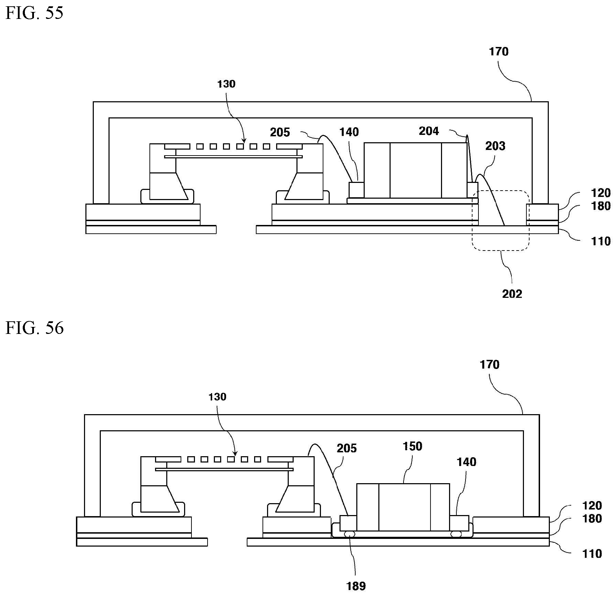

As shown in FIG. 56, flip chip bonding can be applied to directly bond the signal processing element **140** to the first substrate **110**. At this time, flip chip bonding can be applied to the signal processing element **140**. While full etching or half etching is applied to the metal plate that is the second substrate **120**, flip chip bonding can be applied to the signal processing element **140**. Volume expansion is possible through etching of the metal plate, which can improve SNR.

When applying flip chip bonding to the signal processing element **140**, as shown in FIG. 55, the wire bonding wire **203** for connecting the signal processing element **140** and the first substrate **110** with a wire can be deleted, and the wire bonding pad region **202** of the first substrate **110** for wire bonding can also be deleted. As the signal processing element **140** is directly in contact with the first substrate **110** through flip chip bonding, signal loss can be reduced and impedance can be improved.

In addition, the wire bonding pad region **202** is deleted, so the substrate size can be reduced, and through this, the size of the overall package can be reduced.

In the case of FR4 rigid PCB, an embedded signal processing element (ASIC) is required to achieve the same effect, and as a result, an increase in substrate cost is inevitable, however, through etching of the second substrate **120** and flip chip bonding of the signal processing element **140**, the substrate cost can be dramatically reduced while applying the embedded ASIC effect.

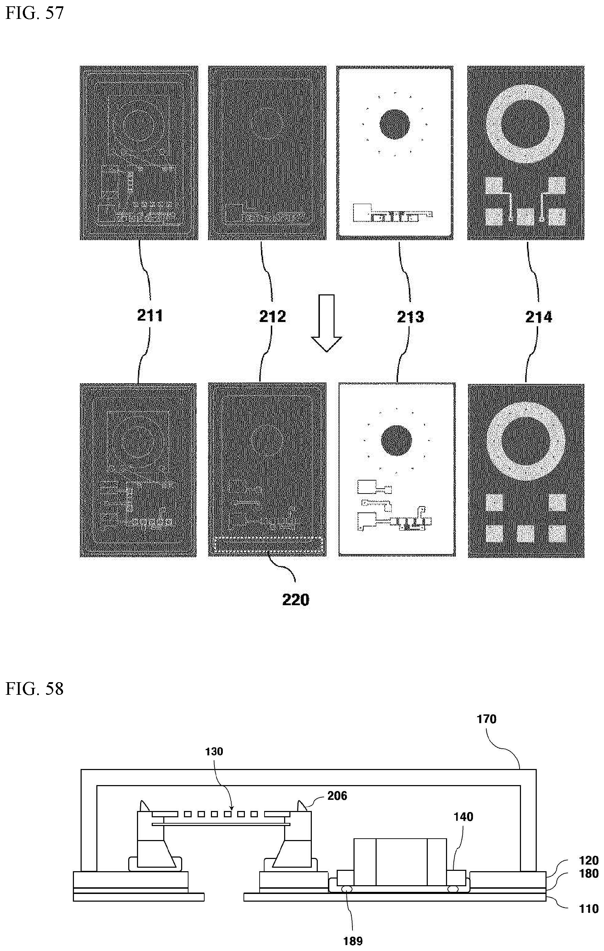

The upper portion of FIG. 57 illustrates wire connections or circuit connections according to an embodiment of FIG. 55; and the lower portion illustrates wire connections or circuit connections according to the embodiment of FIG. 56. Like **211**, wire bonding can be reduced from 11 to 3. In the embodiment of FIG. 55, a total of 11 are needed for: a wire **205** connecting the MEMS structure **130** and the signal processing element **140**; a wire **204** connecting the capacitor **150** and the signal processing element **140**; and a wire **203** connecting the signal processing element **140** and the substrate **110**, however, for the embodiment of FIG. 56, by directly contacting the capacitor **150** and the signal processing element **140** to the first substrate **110** without wire bonding, only 3 wires **205** connecting the capacitor **150** and signal processing element **140** are needed, thereby reducing wire bonding. Here, the first substrate **110** may include a thin film fine-pitch flexible substrate. The wire being deleted may be connected through a circuit, such as **212** (the second substrate **120** and the first substrate **110**) and **213** (the upper layer circuit of the first substrate **110**). In addition, by removing the wire bonding, the wire bonding pad of the first substrate **110** can be deleted, and through this, the size of the MEMS microphone substrate can be reduced, and the size of the entire package can also be reduced.

In addition, since wiring freedom is secured by applying direct bonding, the LAYER BOT circuit of the first substrate **110** can be simplified, such as **214** (LAYER BOT circuit of the first substrate **110**), and from this, there is a process advantage in that there is no need to apply solder resist, and the like to the LAYER BOT.

As the wire bonding pad section is deleted, free space **220** in a lower substrate region is secured, and from this, the substrate length can be reduced and the package size can be reduced. For example, the length of the bottom PCB can be reduced by 0.13 mm, and the package size can be reduced from 3 x 2 mm to 2.87 x 2 mm.

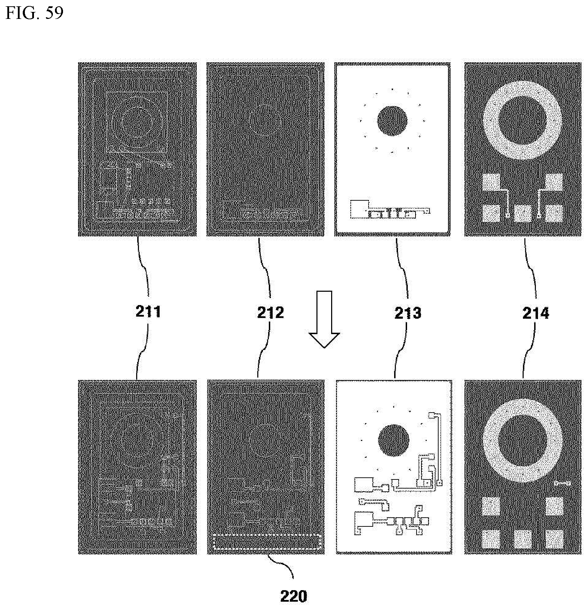

In addition, as shown in FIGS. 58 and 59, the wire bonding length of the MEMS structure **130** can be reduced by applying the direction of the wire bonding to the side rather than the direction of the signal processing element **140**. The reduced wire bonding length can be implemented with a circuit within the substrate, such as the circuit in FIG. 59, and this can reduce costs, and this case also, the wire bonding pad section is deleted, thereby securing the free space **220** in a lower substrate region, and from this, the substrate length can be reduced and the package size can be reduced. For example, the length of the lower side of the PCB can be reduced by 0.13 mm, and the package size can be reduced from 3 x 2 mm to 2.87 x 2 mm.

Those skilled in the art related to this embodiment will understand that the above-described description can be implemented in a modified form without departing from the essential characteristics. Therefore, the disclosed methods should be considered from an explanatory rather than a restrictive perspective. The scope of the present invention is indicated in the claims rather than the foregoing description, and all differences within the equivalent scope should be construed as being included in the present invention.

## Claims

1. A MEMS microphone comprising:
a first substrate;
a second substrate stacked on the first substrate;
a MEMS structure disposed on the second substrate; and
a capacitor spaced apart from the MEMS structure and disposed on the second substrate,
wherein the second substrate comprises one or more of holes, and
wherein the capacitor is electrically connected to the first substrate through a wire passing through the hole of the second substrate.

2. The MEMS microphone according to claim 1,
wherein the hole of the second substrate comprises:
a first hole through which a wire connecting the capacitor and the first substrate penetrates; and
a second hole corresponding to a lower portion of the MEMS structure.

3. The MEMS microphone according to claim 1,
wherein the hole of the second substrate is formed by being spaced apart at a predetermined distance or more from an outer perimeter of the second substrate.

4. The MEMS microphone according to claim 1, comprising:
a conductive adhesive layer between the first substrate and the second substrate, and
wherein the conductive adhesive layer comprises a hole overlapped with the hole of the second substrate.

5. The MEMS microphone according to claim 4,
wherein an area of the hole of the conductive adhesive layer is larger than an area of the hole in the second substrate.

6. The MEMS microphone according to claim 1,
wherein the first substrate comprises a connection pad disposed at a position corresponding to a lower portion of the hole of the second substrate.

7. The MEMS microphone according to claim 1, comprising:
an ASIC module disposed on the second substrate and spaced apart from the MEMS structure,
wherein the ASIC module is electrically connected to the first substrate through a wire passing through the hole of the second substrate.

8. The MEMS microphone according to claim 7,
wherein the ASIC module is electrically connected to the MEMS structure and the capacitor through wires, respectively.

9. The MEMS microphone according to claim 1,
wherein the first substrate is a flexible substrate, and the second substrate is a rigid substrate.

10. The MEMS microphone according to claim 1,
wherein the first substrate and the second substrate are bonded by thermal compression.
